# EUROPEAN PATENT APPLICATION

(11) **EP 4 495 688 A1**
(43) Date of publication of application: **22.01.2025**
(21) Application number: 24183158.5
(22) Date of filing: 19.06.2024
(51) Int. Cl.: G03F 7/09, G03F 7/11

(54) **COMPOUND FOR FORMING METAL-CONTAINING FILM, COMPOSITION FOR FORMING METAL-CONTAINING FILM, PATTERNING PROCESS, AND METHOD FOR MANUFACTURING COMPOUND FOR FORMING METAL-CONTAINING FILM**

(30) Priority: 10.07.2023 JP 2023113111
(71) Applicant: SHIN-ETSU CHEMICAL CO., LTD., Tokyo 1000005 (JP)
(72) Inventor: Kobayashi, Naoki, Niigata (JP); Nagamachi, Nobuhiro, Niigata (JP); Ishiwata, Kenta, Niigata (JP); Kori, Daisuke, Niigata (JP)
(74) Representative: Sonnenhauser, Thomas Martin

(57) **Abstract**

The present invention is a compound for forming a metal-containing film, containing: at least one metal atom selected from the group consisting of Ti, Zr, and Hf; and a ligand coordinated to the metal atom, where the ligand contains a group represented by any of the following formulae (a-1) to (a-3), where R₁ represents a hydrogen atom or an organic group having 1 to 10 carbon atoms, and "*" represents an attachment point. This can provide: a compound for forming a metal-containing film that gives a metal-containing film that makes it possible to obtain an excellent pattern profile, has high adhesiveness to a resist upper layer film, and suppresses fine-pattern collapse in a fine patterning process of a semiconductor device manufacturing process; a composition for forming a metal-containing film, containing the compound; and a patterning process using the composition.

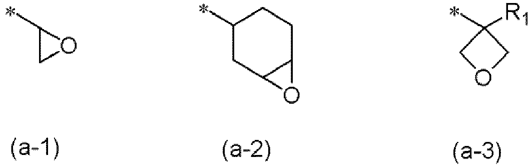

## Description

### TECHNICAL FIELD

The present invention relates to: a compound for forming a metal-containing film; a composition for forming a metal-containing film, containing the compound; a patterning process using the composition; and a method for manufacturing a compound for forming a metal-containing film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist underlayer film having a different etching selectivity from a photoresist film (i.e., a resist upper layer film) is placed between the resist upper layer film and a substrate to be processed; a pattern is formed in the resist upper layer film; the pattern is transferred to the resist underlayer film by dry etching while using the resist upper layer film pattern as a dry etching mask; and the pattern is further transferred to the substrate to be processed by dry etching while using the resist underlayer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

As a silicon-containing resist middle layer film used in a three-layer resist method like the method described above, used are: a silicon-containing inorganic film obtained by CVD, for example, an SiO₂ film (e.g. Patent Document 2 etc.) or an SiON film (e.g. Patent Document 3 etc.); a film obtained by spin-coating, such as an SOG (spin-on-glass) film (e.g. Patent Document 4, Non Patent Document 1, etc.) or a crosslinkable silsesquioxane film (e.g. Patent Document 5 etc.); etc. A polysilane film (e.g. Patent Document 6 etc.) should also be usable. Among these films, an SiO₂ film and an SiON film have high performance as dry etching masks when the organic film underneath is dry-etched, but require special equipment for film formation. On the other hand, an SOG film, a crosslinkable silsesquioxane film, and a polysilane film can be formed just by spin-coating and heating, and are thought to have high process efficiency.

There are some problems with such silicon-containing films, conventionally used in multilayer resist methods. For example, when a resist pattern is to be formed by photolithography, it is well known that exposure light is reflected off a substrate and interferes with incident light, causing a problem in so-called standing waves, and therefore, in order to obtain a fine pattern having no edge roughness of the resist film under the most advanced ArF immersion and high-NA exposure conditions, an antireflective function is essential in a middle layer film. Furthermore, in the most advanced semiconductor processes described above, the thinning of photoresists has progressed considerably, and therefore, resist middle layer films are also required to be thinned. In next-generation exposure processes, it is required to provide an antireflective effect with a film thickness of 30 nm or less. In addition, dry etching speed when using oxygen gas plasma, which is commonly used when processing a resist underlayer film, is preferably low, so as to increase the etching selectivity between a resist middle layer film and a resist underlayer film, and in the course of thinning, resist middle layer films are required to have improved dry etching resistance.

As resist middle layer films that satisfy such requirements for an antireflective effect and dry etching property, metal hard mask films containing Ti or Zr are attracting attention, in place of conventional silicon-containing resist middle layer films. TiO₂ and ZrO₂ are known as high refractive index materials, and it is possible to enhance an antireflective effect under high-NA exposure conditions by these materials being contained in a film. In addition, excellent dry etching resistance to oxygen gas can be expected by metal-oxygen bonds being included.

Moreover, metal hard mask films have excellent dry etching resistance not only to oxygen gas but also to fluorine gas, and therefore, excellent dry etching resistance can also be expected in two-layer resist methods where a metal hard mask film is formed as a resist underlayer film on a substrate to be processed, and a resist upper layer film is formed thereon.

On the other hand, when such a metal hard mask film is used directly under a resist upper layer film, the improvement of adhesiveness to a resist pattern is a problem. A cured metal hard mask film has much higher surface energy (or a smaller contact angle with water) than a photoresist applied subsequently. This mismatch in surface energy causes adhesion failure between the metal hard mask film and the subsequently applied photoresist, and brings about pattern collapse.

Surface modification of the metal hard mask film is necessary for suppressing photoresist pattern collapse on the metal hard mask film, and for example, Patent Document 7 reports a metal hard mask containing a surface-modified organic polymer. It is reported that, by using the difference between the free energies of the organic polymer and the metal compound and allowing the organic polymer to be unevenly distributed on a surface layer, adhesiveness to a resist pattern can be improved. For suppressing pattern collapse, used are organic polymers including surface-treated moieties selected from hydroxyl, protected hydroxyl, protected carboxyl, and mixtures thereof. However, in the current situation, where finer pattern formation is required, it cannot be said that these materials have sufficient pattern collapse suppression performance. In addition, when an organic polymer is contained, there is a risk of dry etching resistance to oxygen gas being degraded, and therefore, there are demands for the development of a compound for forming a metal-containing film excellent in adhesiveness to a resist upper layer film.

Nowadays, it is considered that interaction between a resist upper layer film and a resist underlayer film directly under the resist upper layer film in a fine pattern at the interface also has an influence on the sensitivity of the resists, pattern profile (rectangularity and residue in space portions), etc., and improved performance is required in the resist underlayer film directly under the resist upper layer film from these viewpoints as well (Non Patent Document 2) .

### CITATION LIST

### PATENT LITERATURE

Patent Document 1: JP2004-205685A
Patent Document 2: JPH07-183194A
Patent Document 3: JPH07-181688A
Patent Document 4: JPH05-291208A
Patent Document 5: JP2005-520354A
Patent Document 6: JPH11-060735A
Patent Document 7: JP6463600B2

### NON PATENT LITERATURE

Non Patent Document 1: J. Appl. Polym. Sci., Vol. 88, 636-640 (2003)
Non Patent Document 2: Proc. SPIE Vol. 7273, 72731J (2009)

### SUMMARY OF INVENTION

### TECHNICAL PROBLEM

The present invention has been made in view of the above-described circumstances. An object of the present invention is to provide: a compound for forming a metal-containing film that gives a metal-containing film that makes it possible to obtain an excellent pattern profile, has high adhesiveness to a resist upper layer film, and suppresses fine-pattern collapse in a fine patterning process of a semiconductor device manufacturing process; a method for manufacturing the compound; a composition for forming a metal-containing film, containing the compound; and a patterning process using the composition.

### SOLUTION TO PROBLEM

To achieve the object, the present invention provides a compound for forming a metal-containing film, comprising: at least one metal atom selected from the group consisting of Ti, Zr, and Hf; and a ligand coordinated to the metal atom, wherein the ligand contains a group represented by any of the following formulae (a-1) to (a-3), 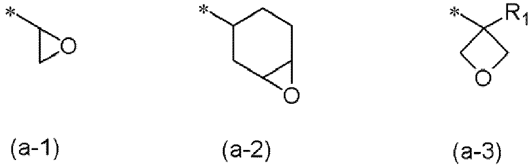 wherein R₁ represents a hydrogen atom or an organic group having 1 to 10 carbon atoms, and "*" represents an attachment point.

When such a compound for forming a metal-containing film is contained in a composition for forming a metal-containing film, it is possible to form a metal-containing film that has high adhesiveness to a resist upper layer film, has an effect of preventing a fine pattern from collapsing, and gives an excellent pattern profile. In addition, the obtained metal-containing film exhibits a high refractive index, and therefore, can exert a high antireflective effect under ArF immersion and high-NA exposure conditions.

Furthermore, the ligand is preferably derived from a structure represented by the following general formula (1) or (2),

RₐXOH (1)

RₐXCOOH (2)

wherein Rₐ represents a group represented by any of the formulae (a-1) to (a-3); and X represents a divalent organic group having 1 to 20 carbon atoms.

When the compound for forming a metal-containing film has a ligand having such a structure, higher adhesiveness to a resist upper layer film can be achieved when the compound is contained in a composition for forming a metal-containing film, and the compound is further effective for preventing fine-pattern collapse.

In this case, it is preferable that the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 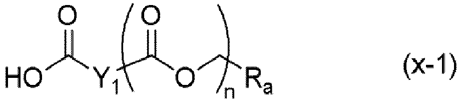 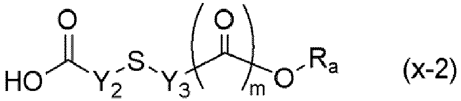 wherein Y₁ to Y₃ each represent a divalent organic group having 1 to 10 carbon atoms; Rₐ is as defined above; "n" represents 0 or 1; and "m" represents 0 or 1, 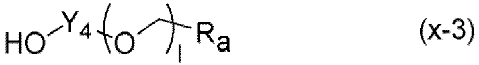 wherein Y₄ represents a divalent organic group having 1 to 10 carbon atoms; Rₐ is as defined above; and "l" represents 0 or 1.

When the ligand has such a structure, the heat resistance of the compound for forming a metal-containing film is improved, and is it possible to form a metal-containing film containing many groups represented by the formulae (a-1) to (a-3), so that the compound is further effective for preventing fine-pattern collapse.

Furthermore, the Y₁ to Y₄ are preferably each a divalent hydrocarbon group having 1 to 10 carbon atoms.

When the ligand has such a structure, the heat resistance of the compound for forming a metal-containing film can be further enhanced.

Furthermore, the compound for forming a metal-containing film is preferably a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),

LₐMX_{b} (3)

wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.

Using such a compound for forming a metal-containing film, it is possible to form a metal-containing film having better dry etching resistance to oxygen gas.

Furthermore, the metal compound preferably has a structure represented by the following general formula (4),

M(OR^{1A})₄ (4)

wherein M is as defined above; and R^{1A} represents a monovalent organic group having 1 to 20 carbon atoms.

The metal compound, having such a structure, is preferable from the viewpoints of productivity and the availability of raw materials.

Furthermore, in the present invention, the compound for forming a metal-containing film preferably further comprises a ligand derived from a silicon compound represented by the following general formula (5), 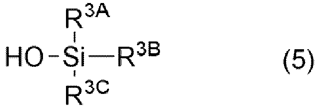 wherein R^{3A}, R^{3B}, and R^{3C} each represent any organic group selected from an organic group having 2 to 30 carbon atoms including a crosslinking group of a structure represented by any of the following general formulae (b-1) to (b-3), a substituted or unsubstituted alkyl group having 1 to 20 carbon atoms, and an aryl group having 6 to 20 carbon atoms, 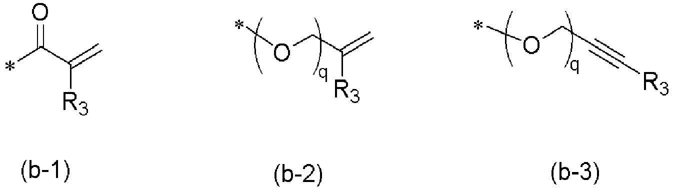 wherein R₃ represents a hydrogen atom or a monovalent organic group having 1 to 10 carbon atoms; "q" represents 0 or 1; and "*" represents an attachment point.

When such a ligand is contained, the stability of the compound for forming a metal-containing film can be further enhanced.

In addition, the present invention provides a composition for forming a metal-containing film, comprising: (A) the above-described compound for forming a metal-containing film; and (B) an organic solvent.

Such a composition for forming a metal-containing film makes it possible to form a metal-containing film that has high adhesiveness to a resist upper layer film, has an effect of preventing a fine pattern from collapsing, and gives an excellent pattern profile. In addition, the obtained metal-containing film exhibits a high refractive index, and therefore, can exert a high antireflective effect under ArF immersion and high-NA exposure conditions.

Furthermore, the composition for forming a metal-containing film can further comprise one or more of (C) a thermal acid generator and (D) a photo-acid generator.

When the composition for forming a metal-containing film contains one or more of such additives, the composition for forming a metal-containing film has a better coating property and better adhesiveness to a resist upper layer film.

Furthermore, the composition for forming a metal-containing film can further comprise one or more of (E) a crosslinking agent and (G) a surfactant.

When the composition for forming a metal-containing film contains one or more of such additives, the composition for forming a metal-containing film has better coating property, dry etching resistance, and filling and/or planarizing properties.

Furthermore, the organic solvent (B) is preferably a mixture of one or more kinds of organic solvent having a boiling point of lower than 180°C and one or more kinds of organic solvent having a boiling point of 180°C or higher.

When flowability is imparted to the composition for forming a metal-containing film by a high-boiling-point solvent being contained, it is possible to suppress the generation of coating defects induced by the composition for forming a metal-containing film being dry.

The present invention also provides a patterning process for forming a pattern in a substrate to be processed, comprising the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the transferred pattern as a mask to form the pattern in the substrate to be processed.

The present invention also provides a patterning process for forming a pattern in a substrate to be processed, comprising the steps of:
(II-1) forming a resist underlayer film on a substrate to be processed;
(II-2) applying the above-described composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the transferred pattern as a mask to form the pattern in the substrate to be processed.

As described, the inventive compound for forming a metal-containing film contains a group selected from the formulae (a-1) to (a-3), and when the compound is contained in a composition for forming a metal-containing film, it is possible to form a metal-containing film excellent in adhesiveness to a resist upper layer film. Therefore, the compound can be used suitably in various patterning processes such as two-layer resist processes and three-layer resist processes. These patterning processes make it possible to suppress pattern collapse effectively by the use of a metal-containing film provided by the present invention and are suitable for photolithography of a resist upper layer film, and also make it possible to transfer a resist upper layer film pattern to a substrate to be processed with high precision.

The present invention also provides a method for manufacturing a compound for forming a metal-containing film, the method comprising performing a reaction between: a metal compound containing at least one metal atom selected from the group consisting of Ti, Zr, and Hf; and a ligand containing a group represented by any of the following formulae (a-1) to (a-3), 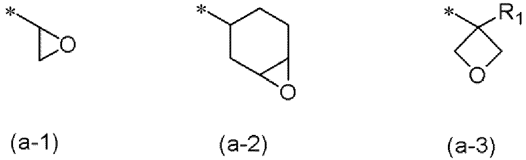 wherein R₁ represents a hydrogen atom or an organic group having 1 to 10 carbon atoms, and "*" represents an attachment point.

According to such a method for manufacturing a compound for forming a metal-containing film, it is possible to manufacture easily a compound for forming a metal-containing film to be contained in a composition for forming a metal-containing film with which it is possible to form a metal-containing film that has high adhesiveness to a resist upper layer film, has an effect of preventing fine-pattern collapse, and also gives an excellent pattern profile.

In this event, the ligand preferably has a structure represented by the following general formula (1) or (2),

RₐXOH (1)

RₐXCOOH (2)

wherein Rₐ represents a group represented by any of the formulae (a-1) to (a-3); and X represents a divalent organic group having 1 to 20 carbon atoms.

By using such a ligand, it is possible to manufacture a compound for forming a metal-containing film that can achieve higher adhesiveness to a resist upper layer film and is further effective for preventing a fine pattern from collapsing when the compound is contained in a composition for forming a metal-containing film.

Furthermore, in the ligand, it is preferable that the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 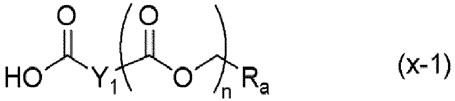 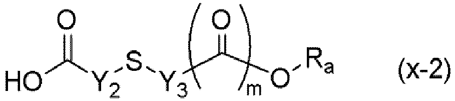 wherein Y₁ to Y₃ each represent a divalent organic group having 1 to 10 carbon atoms; Rₐ is as defined above; "n" represents 0 or 1; and "m" represents 0 or 1, 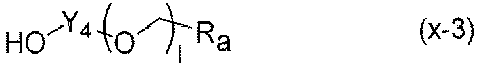 wherein Y₄ represents a divalent organic group having 1 to 10 carbon atoms; Rₐ is as defined above; and "l" represents 0 or 1.

By using a ligand having such a structure, it is possible to manufacture a compound for forming a metal-containing film that has improved heat resistance, makes it possible to form a metal-containing film containing many groups represented by the formulae (a-1) to (a-3), and is further effective for preventing a fine pattern from collapsing.

Furthermore, the Y₁ to Y₄ are preferably each a divalent hydrocarbon group having 1 to 10 carbon atoms.

By using a ligand having such a structure, it is possible to manufacture a compound for forming a metal-containing film having better heat resistance.

Furthermore, the compound for forming a metal-containing film is preferably a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),

LₐMX_{b} (3)

wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.

By using such a compound for forming a metal-containing film, it is possible to form a metal-containing film having better dry etching resistance to oxygen gas.

In this event, the metal compound preferably has a structure represented by the following general formula (4),

M(OR^{1A})₄ (4)

wherein M is as defined above; and R^{1A} represents a monovalent organic group having 1 to 20 carbon atoms.

It is preferable to use a metal compound having such a structure from the viewpoints of productivity and the availability of raw materials.

### ADVANTAGEOUS EFFECTS OF INVENTION

As described above, the present invention provides: a compound for forming a metal-containing film that has high adhesiveness to a resist upper layer film and has a fine-pattern collapse-suppression effect; a method for manufacturing the compound; a composition for forming a metal-containing film, containing the compound; and a patterning process using the composition.

A metal-containing film formed by using a conventional compound for forming a metal-containing film has much higher surface energy (or a smaller contact angle with water) than a photoresist film applied subsequently. This mismatch in surface energy causes adhesion failure between the metal-containing film and the subsequently applied photoresist film, and brings about pattern collapse. In addition, in a case where an organic polymer is contained as a surface modifier, the dry etching resistance when processing the metal-containing film is insufficient, and there is a risk of pattern transfer failure being induced.

However, the inventive compound for forming a metal-containing film contains a group represented by any of the formulae (a-1) to (a-3), and therefore, when contained in a composition for forming a metal-containing film, makes it possible to form a metal-containing film having excellent adhesiveness to a resist upper layer film. Therefore, the inventive compound not only has a fine-pattern collapse-suppression effect, but also gives a substrate to be processed a high-rectangularity resist upper layer film pattern profile, and therefore, the compound is extremely useful in multilayer resist processes. Moreover, the inventive composition for forming a metal-containing film is excellent in resistance to dry etching using each one of oxygen gas and fluorine gas, and therefore, makes it possible to form highly accurately a fine pattern in a substrate to be processed in various patterning processes such as two-layer resist processes and three-layer resist processes.

### BRIEF DESCRIPTION OF DRAWINGS

FIG. 1 is an explanatory diagram of an example (three-layer resist process) of the inventive patterning process.
FIG. 2 is an explanatory diagram of an example (two-layer resist process) of the inventive patterning process.
FIG. 3 is an explanatory diagram of reflectance calculation in a patterning process.

### DESCRIPTION OF EMBODIMENTS

As stated above, there have been demands for the development of: a compound for forming a metal-containing film that gives a metal-containing film in which it is possible to achieve an excellent pattern profile and which has high adhesiveness to a resist upper layer film so that fine-pattern collapse can be suppressed in a fine patterning process of a semiconductor device manufacturing process; a method for manufacturing the compound; a composition for forming a metal-containing film, containing the compound; and a patterning process using the composition.

The present inventors have studied the above-described object earnestly and found out that the object can be achieved by a compound for forming a metal-containing film, containing a ligand having a specific structure described below, a method for manufacturing the compound, a composition for forming a metal-containing film, containing the compound, and a patterning process in which the composition is used, and completed the present invention.

That is, the present invention is a compound for forming a metal-containing film, comprising: at least one metal atom selected from the group consisting of Ti, Zr, and Hf; and a ligand coordinated to the metal atom, wherein the ligand contains a group represented by any of the following formulae (a-1) to (a-3), 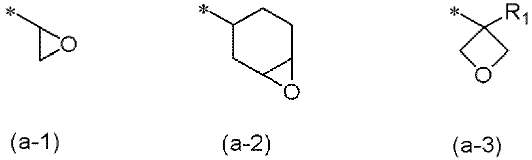 wherein R₁ represents a hydrogen atom or an organic group having 1 to 10 carbon atoms, and "*" represents an attachment point.

Hereinafter, the present invention will be described in detail, but the present invention is not limited thereto.

### [(A) Compound for Forming Metal-Containing Film]

The present invention is a compound for forming a metal-containing film, containing: at least one metal atom selected from the group consisting of Ti, Zr, and Hf; and a ligand coordinated to the metal atom, where the ligand contains a group represented by any of the following formulae (a-1) to (a-3).

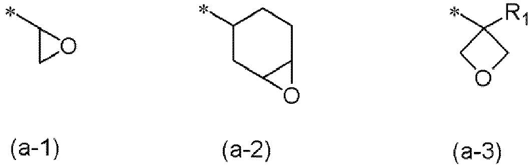

In the formulae, R₁ represents a hydrogen atom or an organic group having 1 to 10 carbon atoms, and "*" represents an attachment point.

When such a heterocyclic structure is contained, the epoxy or oxetane structure undergoes a ring-opening reaction during heating for film formation, and thus, the film is cured. Moreover, the hydroxy groups generated by this ring-opening reaction also contribute to improvement in adhesiveness to a resist upper layer film.

The R₁ in the formula (a-3) represents a hydrogen atom or an organic group having 1 to 10 carbon atoms, preferably a hydrogen atom, a methyl group, or an ethyl group, more preferably an ethyl group.

The ligand is preferably derived from a structure represented by the following general formula (1) or (2).

RₐXOH (1)

RₐXCOOH (2)

In the formulae, Rₐ represents a group represented by any of the formulae (a-1) to (a-3); and X represents a divalent organic group having 1 to 20 carbon atoms.

The X in the formulae represents a divalent organic group having 1 to 20 carbon atoms, and may contain one or more kinds selected from an oxygen atom, a nitrogen atom, and a sulfur atom.

It is preferable for the ligand contained in the compound for forming a metal-containing film to be a ligand derived from the above-described structures from the viewpoint of the productivity of the compound for forming a metal-containing film. This is also favorable from the viewpoint of the availability of raw materials on providing a compound for forming a metal-containing film, having a ligand containing any of the groups represented by the formulae (a-1) to (a-3).

Furthermore, it is preferable that the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3).

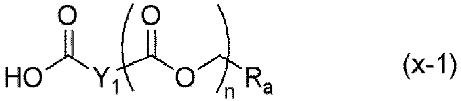

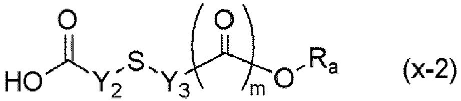

In the formulae, Y₁ to Y₃ each represent a divalent organic group having 1 to 10 carbon atoms; Rₐ is as defined above; "n" represents 0 or 1; and "m" represents 0 or 1.

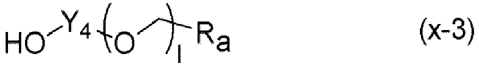

In the formula, Y₄ represents a divalent organic group having 1 to 10 carbon atoms; Rₐ is as defined above; and "l" represents 0 or 1.

The Y₁ to Y₄ are more preferably each a divalent hydrocarbon group having 1 to 10 carbon atoms from the viewpoint of heat resistance.

As specific examples of the structure represented by the general formula (x-1), the following structures are favorable.

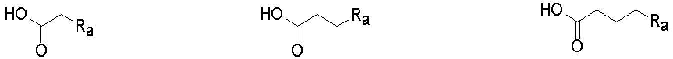

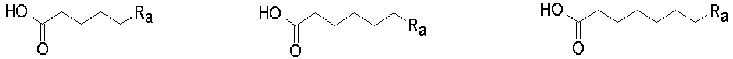

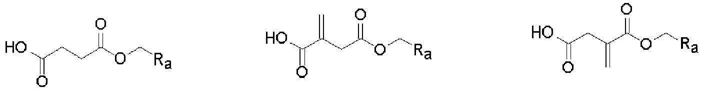

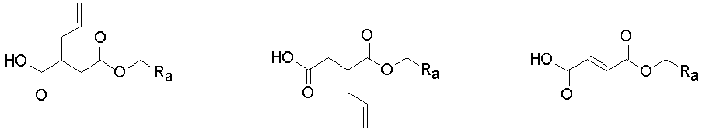

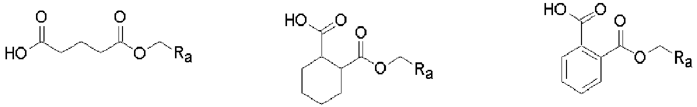

In the formulae, Rₐ is as defined above.

As specific examples of the structures represented by the general formula (x-2), the following structures are favorable.

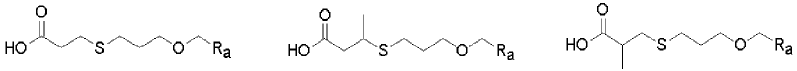

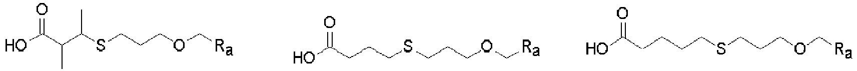

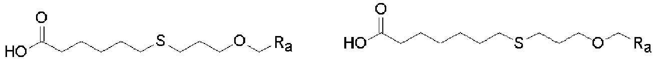

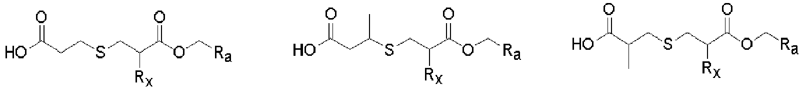

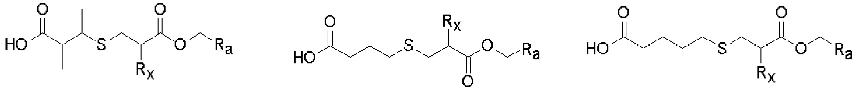

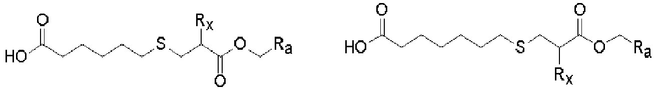

In the formulae, Rₐ is as defined above, and Rₓ represents a hydrogen atom or a monovalent organic group having 1 to 10 carbon atoms.

As specific examples of the structure represented by the general formula (x-3), the following structures are favorable.

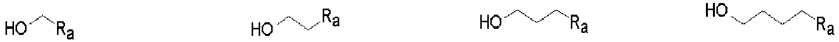

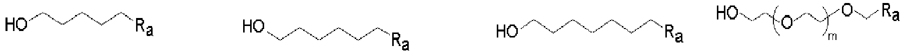

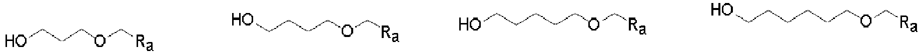

In the formulae, Rₐ is as defined above, and "m" represents 0 to 4.

In the case of the general formula (x-2), Rₐ is more preferably a group represented by the formula (a-3) from the viewpoint of the availability of raw materials.

The compound for forming a metal-containing film is preferably a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2).

LₐMX_{b} (3)

In the formula, M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.

Such a compound for forming a metal-containing film makes it possible to form a metal-containing film excellent in dry etching resistance to oxygen gas when the compound is contained in a composition for forming a metal-containing film.

### [(a) Metal Compound and Metal-Containing Compound] (Hydrolysable Group)

Examples of the hydrolysable group X of the general formula (3) include one or more selected from halogen atoms, alkoxy groups, carboxylate groups, acyloxy groups, and -NR¹R². R¹ and R² each independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR¹R² include an unsubstituted amino group, a methylamino group, a dimethylamino group, a diethylamino group, a dipropylamino group, etc.

As the hydrolysable group X, an alkoxy group is preferable, and an i-propoxy group, an n-butoxy group, or a t-butoxy group is more preferable.

### (Monodentate Ligand)

Examples of the monodentate ligand include a hydroxo ligand, a carboxy ligand, an amido ligand, an amine ligand, an ammonia ligand, an olefin ligand, etc.

Examples of the carboxy ligand include a formate ligand (OOCH), an acetate ligand (OOCMe), a propionate ligand (OOCEt), and a butyrate ligand (OOCPr).

Examples of the amido ligand include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligand include pyridine, a trimethylamine ligand, a piperidine ligand, etc.

Examples of the olefin ligand include: linear olefins, such as ethylene and propylene; cyclic olefins, such as cyclopentene, cyclohexene, and norbornene; etc.

### (Polydentate Ligand)

Examples of the polydentate ligand include a ligand derived from a hydroxy acid ester, a ligand derived from a β-diketone, a ligand derived from a β-keto ester, a ligand derived from an α,α-dicarboxylic acid ester, a hydrocarbon having a π bond, diphosphine, etc.

Examples of the hydroxy acid ester include glycolic acid esters, lactic acid esters, 2-hydroxycyclohexane-1-carboxylic acid esters, salicylic acid esters, etc.

Examples of the β-keto ester include acetoacetic acid esters, α-alkyl-substituted acetoacetic acid esters, β-ketopentanoic acid esters, benzoylacetic acid esters, 1,3-acetonedicarboxylic acid esters, etc.

Examples of the β-diketone include acetylacetone, methylacetylacetone, and ethylacetylacetone.

Examples of the α,α-dicarboxylic acid ester include malonic acid diesters, α-alkyl-substituted malonic acid diesters, α-cycloalkyl-substituted malonic acid diesters, α-aryl-substituted malonic acid diesters, etc.

Examples of the hydrocarbon having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, etc.

In the general formula (3), a+b = 4, and "a" and "b" each represent an integer of 0 to 4. "a" is preferably 0 to 3, more preferably 0 to 2, further preferably 1 or 2, and particularly preferably 2. "b" is preferably 2 to 4, more preferably 2 or 3, and further preferably 2. By setting "a" and "b" to be within the above ranges, the stability of the compound for forming a metal-containing film can be enhanced.

Examples of the metal compound and metal-containing compound (a) include: compounds containing titanium, such as diisopropoxybis(2,4-pentanedionate)titanium(IV), tetra-n-butoxytitanium(IV), tetra-n-propoxytitanium(IV), tri-n-butoxymonostearatetitanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV); compounds containing zirconium, such as dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono(2,4-pentanedionate)zirconium(IV), triisopropoxymono(2,4-pentanedionate)zirconium(IV), tri(3-methacryloxypropyl)methoxyzirconium(IV), and tri(3-acryloxypropyl)methoxyzirconium(IV); and compounds containing hafnium, such as diisopropoxybis(2,4-pentanedionate)hafnium(IV), tetrabutoxyhafnium(IV), tetraisopropoxyhafnium(IV), tetraethoxyhafnium(IV), and dichlorobis(cyclopentadienyl)hafnium(IV) .

From the viewpoint of the availability of raw materials, the metal compound preferably has a structure represented by the following general formula (4).

M(OR^{1A})₄ (4)

In the formula, M is as defined above; and R^{1A} represents a monovalent organic group having 1 to 20 carbon atoms.

In the general formula (4), R^{1A} represents a monovalent organic group having 1 to 20 carbon atoms, preferably a methyl group, an ethyl group, an n-propyl group, an i-propyl group, an n-butyl group, or a t-butyl group, and more preferably an isopropyl group, an n-butyl group, or a t-butyl group.

At the time of the synthesis reaction of the compound for forming a metal-containing film, a compound that may become a monodentate ligand or a polydentate ligand (hereinafter, compound (b) for forming a ligand) in the compound for forming a metal-containing film can be contained besides the metal compound or metal-containing compound (a) and the structure including any of the groups represented by the formulae (a-1) to (a-3).

Examples of the compound (b) for forming a ligand include compounds, such as organic compounds derived from a hydroxo ligand, a carboxy ligand, an amido ligand, an amine ligand, an ammonia ligand, an olefin ligand, etc. and organic compounds derived from a ligand derived from a hydroxy acid ester, a ligand derived from a β-diketone, a ligand derived from a β-keto ester, a ligand derived from an α,α-dicarboxylic acid ester, etc., given as examples of the L in the general formula (3). Examples also include compounds having multiple hydroxy groups etc.

Furthermore, the compound (b) for forming a ligand may be an organic compound having 1 to 30 carbon atoms including at least one crosslinking group represented by any of the following general formulae (c-1) to (c-4), (d-1) to (d-4), and (e-1) to (e-3). 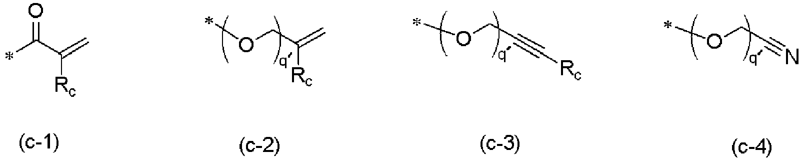 In the formulae, R_{c} represents a hydrogen atom or a monovalent organic group having 1 to 10 carbon atoms; "q'" represents 0 or 1; and "*" represents an attachment point. 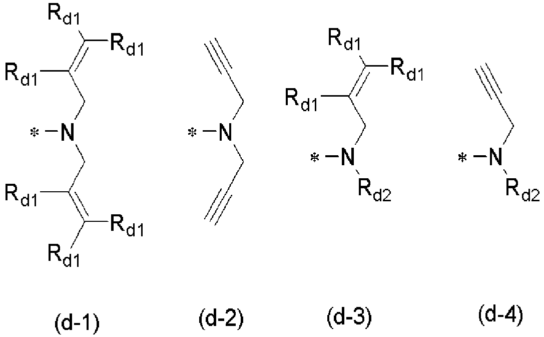 In the formulae, R_{d1}s each represent a hydrogen atom or a methyl group and are identical to or different from each other in a single formula; R_{d2} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; and "*" represents an attachment point.

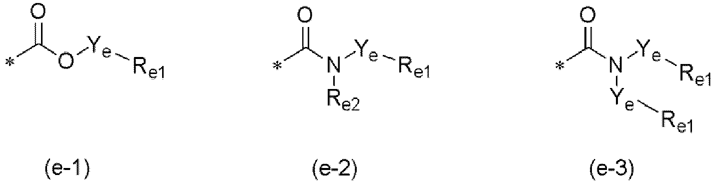

In the formulae, Yₑ represents a divalent organic group having 1 to 20 carbon atoms; Rₑ₂ represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; Rₑ₁ represents an organic group whose protecting group is to be removed by an action of an acid, heat, or both to generate one or more hydroxy groups or carboxy groups, Rₑ₁ being represented by one of the following general formulae (e-4); and "*" represents an attachment point.

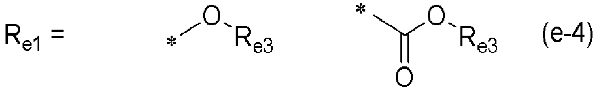

In the formulae, Rₑ₃ represents an organic group whose protecting group is to be removed by an action of an acid, heat, or both; and "*" represents an attachment point to Yₑ.

When the compound for forming a metal-containing film contains at least one crosslinking group represented by any of the general formulae (c-1) to (c-4), (d-1) to (d-4), and (e-1) to (e-3), sufficient thermal flowability can be achieved at the time of film formation, and therefore, when the compound is contained in a composition for forming a metal-containing film, it is possible to form a metal-containing film excellent in flatness.

From the viewpoints of the productivity and stability of the compound for forming a metal-containing film, the compound (b) for forming a ligand is more preferably a compound derived from a carboxy ligand, a compound derived from a ligand derived from a β-diketone, or a compound having a plurality of hydroxy groups. One kind of these compounds may be used, or two or more kinds thereof may be used in combination.

Examples of the compound derived from a carboxy ligand include compounds represented by the following general formula (5').

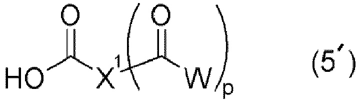

In the formula, "p" represents 0 or 1. When "p" is 1, X¹ represents a divalent organic group having 2 to 20 carbon atoms, and W represents an alkoxy group having 1 to 10 carbon atoms, the following general formula (5-A), or a crosslinking group represented by any of the general formulae (d-1) to (d-4). When "p" is 0, X¹ represents a monovalent organic group having 8 to 30 carbon atoms including an aromatic ring and a crosslinking group of either of the structures represented by the general formulae (c-2) and (c-3).

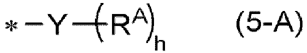

In the formula, Y represents a saturated organic group having a valency of h+1 and having 1 to 20 carbon atoms or an unsaturated organic group having a valency of h+1 and having 2 to 20 carbon atoms; R^{A} represents any of the crosslinking groups represented by the general formulae (c-1) to (c-4); "h" represents 1 to 6; and "*" represents an attachment point to a carbon atom of a carbonyl group.

A compound for forming a metal-containing film, containing a carboxy ligand having such a structure, can improve thermosetting property when a composition for forming a metal-containing film is formed, and makes it possible to form a metal-containing film excellent in resistance against mixing with a resist upper layer film.

In the general formula (5'), it is preferable that "p" is 1 and W has a structure represented by the following general formula (5-B-1) or (5-B-2).

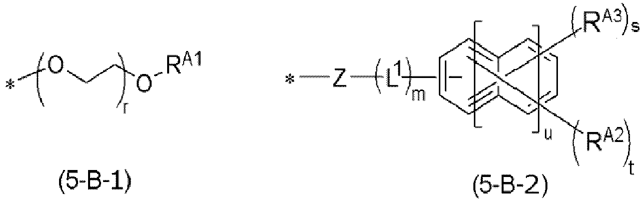

In the formulae, R^{A1} represents a crosslinking group represented by the general formula (c-1); R^{A2} represents a crosslinking group represented by the general formula (c-2) or (c-3); Z represents an oxygen atom or a secondary amine; L¹ represents a divalent hydrocarbon group having 1 to 10 carbon atoms; and R^{A3} represents a saturated monovalent organic group having 1 to 20 carbon atoms or an unsaturated monovalent organic group having 2 to 20 carbon atoms. "u" represents 0 or 1. When "u" is 0, "t" is 1 to 5 and "s" is 0 to 4, provided that t+s is 1 or more and 5 or less, and when "u" is 1, "t" is 1 to 6 and "s" is 0 to 5, provided that t+s is 1 or more and 6 or less. "r" represents 1 to 10; "m" represents 0 or 1; and "*" represents an attachment point to a carbon atom of a carbonyl group.

A compound for forming a metal-containing film, containing a carboxy ligand having such a structure, can improve heat resistance when a composition for forming a metal-containing film is formed, and therefore, a formed metal-containing film exhibits excellent film-formability. It is also possible to suppress the generation of sublimation products during heat-curing and, therefore, to prevent the contamination of equipment.

In the general formula (5'), it is preferable that "p" is 1, W is an alkoxy group having 1 to 10 carbon atoms, and X¹ is any of the structures represented by the following general formulae (5-C).

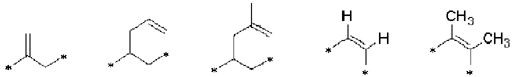

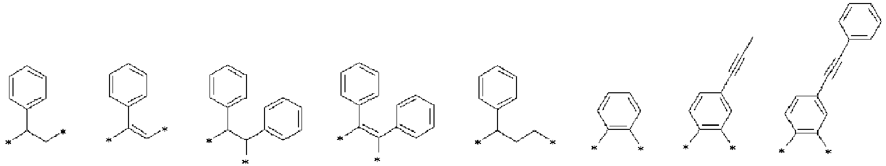

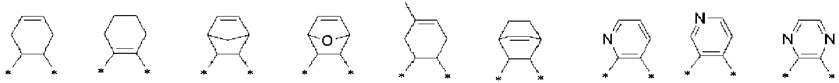

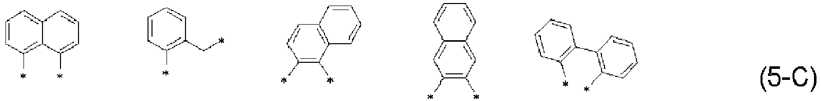

In the formulae, "*" represents an attachment point to a carbon atom of a carbonyl group.

A compound for forming a metal-containing film, containing a carboxy ligand having such a structure, can improve heat resistance when a composition for forming a metal-containing film is formed, and therefore, a formed metal-containing film exhibits excellent film-formability. It is also possible to suppress the generation of sublimation products during heat-curing and, therefore, to prevent the contamination of equipment.

Alternatively, in the general formula (5'), it is also preferable that "p" is 0, and X¹ has one of the structures represented by the following formulae (5-D).

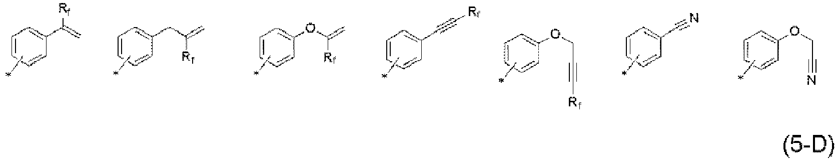

In the formulae, R_{f} represents a hydrogen atom or a monovalent organic group having 1 to 10 carbon atoms; and "*" represents an attachment point to a carbon atom of a carbonyl group.

Other examples of the compound derived from a carboxy ligand include compounds represented by the following general formula (6).

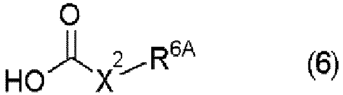

In the formula, X² represents a divalent organic group having 1 to 31 carbon atoms; and R^{6A} represents any of the general formulae (e-1) to (e-3).

In the general formula (6), X² represents a divalent organic group having 1 to 31 carbon atoms, and in view of thermosetting property, preferably represents a saturated hydrocarbon group having 1 to 20 carbon atoms or an unsaturated hydrocarbon group having 2 to 20 carbon atoms.

In the general formulae (e-1) to (e-3), Yₑ represents a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, and Yₑ is preferably a saturated hydrocarbon group having 1 to 20 carbon atoms or an unsaturated hydrocarbon group having 2 to 20 carbon atoms.

When the Yₑ in the general formulae (e-1) to (e-3) is a saturated hydrocarbon group having 1 to 20 carbon atoms or an unsaturated hydrocarbon group having 2 to 20 carbon atoms, the thermosetting property of a composition for forming a metal-containing film can be further improved when the composition is formed with the compound for forming a metal-containing film. This is also desirable from the viewpoint of the availability of raw materials.

Specific examples of Yₑ include the following structures, but are not limited thereto.

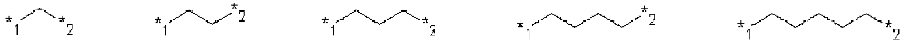

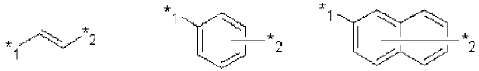

"*₁" represents an attachment point to an oxygen atom or a nitrogen atom; and "*₂" represents an attachment point to Rₑ₁.

The Rₑ₃ in the general formula (e-4) represents an organic group whose protecting group is to be removed by an action of an acid, heat, or both, preferably represents a tertiary hydrocarbyl group, or a group that forms an acetal structure together with an adjacent oxygen atom, and particularly preferably represents a tertiary hydrocarbyl group. As the tertiary hydrocarbyl group, those having 4 to 20 carbon atoms are preferable, and in particular, those having fewer carbon atoms are more preferable.

Examples of the compound derived from a ligand derived from a β-diketone include compounds represented by the following general formula (7).

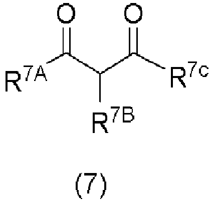

In the formula, R^{7A} to R^{7c} each represent a hydrogen atom or a monovalent organic group having 1 to 20 carbon atoms and optionally containing a crosslinking group represented by any of the general formulae (c-1) to (c-4) and (d-1) to (d-4).

The compounds of the general formula (7) preferably contain at least one crosslinking group represented by any of the general formulae (c-1) to (c-4) and (d-1) to (d-4). Such a compound is capable of further improving the thermosetting property of a composition for forming a metal-containing film when the composition is formed with the compound for forming a metal-containing film, and is therefore preferable.

Examples of the compound having multiple hydroxy groups include dihydric alcohols represented by any of the following general formulae (7-A) to (7-C) etc.

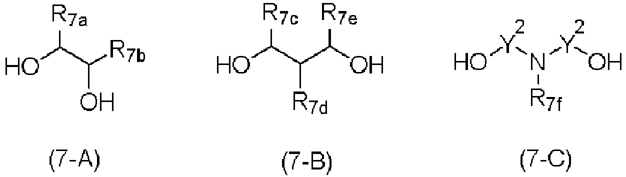

In the formulae, R₇ₐ and R_{7b} each represent a hydrogen atom or a monovalent organic group having 1 to 20 carbon atoms and optionally containing a crosslinking group represented by any of the general formulae (c-1) to (c-4); R_{7c} to R_{7f} each represent a hydrogen atom or a monovalent organic group having 1 to 20 carbon atoms and optionally containing a crosslinking group represented by any of the general formulae (c-1) to (c-4) and (d-1) to (d-4); and Y² represents a divalent organic group having 1 to 10 carbon atoms. In the general formula (7-A), the adjacent R₇ₐ and R_{7b} may be bonded to each other to form an unsaturated or saturated cyclic structure.

The compounds of the general formulae (7-A) to (7-C) preferably contain at least one crosslinking group represented by any of the general formulae (c-1) to (c-4) and (d-1) to (d-4). Such a compound is capable of further improving the thermosetting property of a composition for forming a metal-containing film when the composition is formed with the compound for forming a metal-containing film, and is therefore preferable.

In the compound for forming a metal-containing film, the ligand containing any of the groups represented by the formulae (a-1) to (a-3) is preferably contained in an amount of 10 mol% to 90 mol%, more preferably 20 mol% to 80 mol%, and further preferably 25 mol% to 75 mol% of the total amount of ligands coordinated to the metal atom. The ligand derived from the compound (b) for forming a ligand is preferably contained in an amount of 0 mol% to 50 mol%, more preferably 0 mol% to 30 mol% of the total amount of ligands coordinated to the metal atom. Ligands other than the ligand of the compound (b) for forming a ligand, for example, a ligand derived from an alkoxy group having 1 to 10 carbon atoms, are preferably contained in an amount of 0 mol% to 90 mol%, more preferably 20 mol% to 80 mol% of the total amount of ligands coordinated to the metal atom.

Furthermore, on the occasion of the synthesis reaction of the compound for forming a metal-containing film, a silicon-containing compound (c) may be added besides the metal compound or metal-containing compound (a) and the structure including any of the groups represented by the formulae (a-1) to (a-3).

By substituting a hydrolysable group of the metal compound or metal-containing compound (a) with the silicon-containing compound (c), it is possible to enhance the stability of the compound for forming a metal-containing film in the composition for forming a metal-containing film.

That is, the compound for forming a metal-containing film preferably further contains a ligand derived from a silicon compound represented by the following general formula (5).

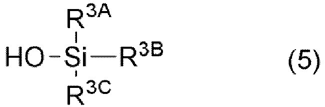

In the formula, R^{3A}, R^{3B}, and R^{3C} each represent any organic group selected from an organic group having 2 to 30 carbon atoms including a crosslinking group of a structure represented by any of the following general formulae (b-1) to (b-3), a substituted or unsubstituted alkyl group having 1 to 20 carbon atoms, and an aryl group having 6 to 20 carbon atoms.

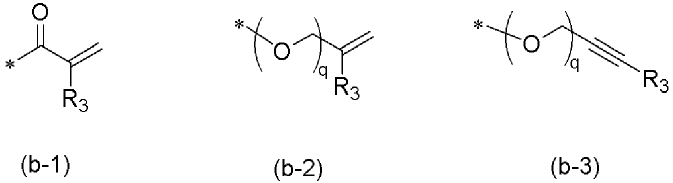

In the formulae, R₃ represents a hydrogen atom or a monovalent organic group having 1 to 10 carbon atoms; "q" represents 0 or 1; and "*" represents an attachment point.

As the silicon-containing compound, a compound of any of the following formulae is preferable, and from the viewpoint of productivity, trimethylsilanol is more preferable.

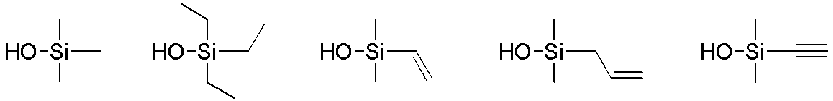

When the compound for forming a metal-containing film contains the ligand containing any of the groups represented by the formulae (a-1) to (a-3) and the ligand derived from the silicon-containing compound (c), the amount of the ligand containing any of the groups represented by the formulae (a-1) to (a-3) contained in the compound for forming a metal-containing film is preferably 10 mol% to 90 mol%, more preferably 20 mol% to 80 mol%, and further preferably 25 mol% to 75 mol% of the total amount of ligands coordinated to the metal atom. The ligand derived from the silicon-containing compound (c) is preferably contained in an amount of 10 mol% to 90 mol%, more preferably 20 mol% to 80 mol% of the total amount of ligands coordinated to the metal atom. Ligands other than the ligand containing any of the groups represented by the formulae (a-1) to (a-3) and the ligand derived from the silicon-containing compound (c), for example, a ligand derived from an alkoxy group having 1 to 10 carbon atoms, are preferably contained in an amount of 0 mol% to 90 mol%, more preferably 20 mol% to 80 mol% of the total amount of ligands coordinated to the metal atom.

### [Method for Manufacturing Compound for Forming Metal-Containing Film]

In addition, the present invention provides a method for manufacturing a compound for forming a metal-containing film, the method including performing a reaction between: a metal compound containing at least one metal atom selected from the group consisting of Ti, Zr, and Hf; and a ligand containing a group represented by any of the formulae (a-1) to (a-3).

In this event, a ligand having a structure represented by the general formula (1) or (2) is preferably used as the ligand.

Furthermore, as the ligand, it is preferable to use a ligand in which the X is a hydrocarbon group having 1 to 10 carbon atoms, the structure represented by the general formula (2) is a structure represented by the general formula (x-1) or (x-2), or the structure represented by the general formula (1) is a structure represented by the formula (x-3).

In this event, the Y₁ to Y₄ are preferably each a divalent hydrocarbon group having 1 to 10 carbon atoms.

Furthermore, as the compound for forming a metal-containing film, it is preferable to use a reaction product of a reaction between: a metal compound represented by the general formula (3) or a metal-containing compound containing a hydrolysate, condensate, or hydrolysis condensate of the metal compound represented by the general formula (3); and the structure represented by the general formula (1) or (2).

In this event, as the metal compound, it is preferable to use a metal compound having a structure represented by the general formula (4).

The metal compound used in the present invention is not particularly limited as long as the metal compound contains at least one kind of metal atom selected from the group consisting of Ti, Zr, and Hf.

When a compound for forming a metal-containing film, containing a ligand containing any of the groups represented by the formulae (a-1) to (a-3), is to be synthesized, the synthesis method is not particularly limited as long as the compound for forming a metal-containing film contains the ligand containing any of the groups represented by the formulae (a-1) to (a-3). For example, a metal alkoxide or a metal acetylacetonate (acac) can be used as the metal compound or metal-containing compound (a), and the compound for forming a metal-containing film can be obtained by allowing the metal alkoxide or metal acac to react with the ligand containing any of the groups represented by the formulae (a-1) to (a-3). The metal compound (a) may be subjected to hydrolysis condensation and then the product may be allowed to react with the ligand containing any of the groups represented by the formulae (a-1) to (a-3), or the metal compound (a) may be allowed to react with the ligand containing any of the groups represented by the formulae (a-1) to (a-3) and then the product may be subjected to hydrolysis condensation. If it is difficult to control the hydrolysis condensation, the reaction with the ligand containing any of the groups represented by the formulae (a-1) to (a-3) may be performed in a non-hydrous environment. The method is preferably adjusted appropriately in accordance with the properties required in the compound for forming a metal-containing film and the metal-containing film. When the ligand derived from the silicon-containing compound (c) and the ligand containing any of the groups represented by the formulae (a-1) to (a-3) are to be contained as ligands, it is preferable to allow the metal compound or metal-containing compound (a) and the silicon-containing compound (c) to react and then allow the product to react with the ligand containing any of the groups represented by the formulae (a-1) to (a-3).

As a method for performing a hydrolysis condensation reaction using the metal compound (a), examples include a method of subjecting the metal compound (a) to a hydrolysis condensation reaction in a solvent containing water. In this case, another compound having a hydrolysable group may be added as necessary. In addition, as a catalyst for the hydrolysis condensation reaction, an acid, such as acetic acid, may be added. The lower limit of the amount of water used in this hydrolysis condensation reaction is preferably 0.2-fold, more preferably 1-fold, and further preferably 3-fold, relative to the hydrolysable groups contained in the metal compound (a) etc., on the molar basis. The upper limit of the amount of the water is preferably 20-fold, more preferably 15-fold, and further preferably 10-fold on the molar basis.

The solvent used in the synthesis reaction of the compound for forming a metal-containing film is not particularly limited, and for example, a solvent given as an example of the organic solvent (B) described later can be used. Typical solvents and solvent mixtures contain an ester, ether, or alcohol functional group, and examples thereof include a mixture of propylene glycol monomethyl ether acetate (PGMEA) and propylene glycol monomethyl ether (PGME) at a ratio of 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### [Composition for Forming Metal-Containing Film]

In addition, the present invention provides a composition for forming a metal-containing film, containing: (A) the above-described compound for forming a metal-containing film; and (B) an organic solvent.

In this case, the composition for forming a metal-containing film preferably contains one or more of (C) a thermal acid generator and (D) a photo-acid generator, and the composition for forming a metal-containing film preferably further contains one or more of (E) a crosslinking agent and (G) a surfactant.

In the following, each of the components contained in the inventive composition for forming a metal-containing film will be described in detail.

### [(B) Organic Solvent]

The organic solvent (B) usable in the inventive composition for forming a metal-containing film is not particularly limited as long as the organic solvent is capable of dissolving or dispersing the compound (A) for forming a metal-containing film, and when contained, (C) a thermal acid generator, (D) a photo-acid generator, (E) a crosslinking agent, (G) a surfactant, other additives, etc. described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent (B) is preferably contained in an amount of 200 to 10,000 parts by mass, more preferably 250 to 5,000 parts by mass relative to 100 parts by mass of the compound (A) for forming a metal-containing film.

Furthermore, the organic solvent (B) may be a mixture of one or more organic solvents having a boiling point of lower than 180°C and one or more organic solvents having a boiling point of 180°C or higher. In the present invention, an organic solvent having a boiling point of 180°C or higher is also referred to as a high-boiling-point organic solvent. Note that, the boiling point is a boiling point at normal pressure.

The high-boiling-point organic solvent is not particularly limited to hydrocarbons, alcohols, ketones, esters, ethers, or chlorine-based solvents, as long as the solvent is capable of dissolving or dispersing the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point organic solvent may be selected suitably from the solvents above, for example, depending on the temperature at which the inventive composition for forming a metal-containing film is heat-treated, etc. The boiling point of the high-boiling-point organic solvent is preferably 180°C to 300°C, further preferably 200°C to 300°C. When the boiling point is as described, the evaporation rate at the baking (heating) is appropriate, and therefore, it is possible to suppress the generation of dryness-induced defects at the time of film formation. Moreover, a solvent having such a boiling point evaporates after the baking and does not remain in the film. Therefore, the solvent does not affect the physical properties, such as etching resistance, of the film.

Furthermore, when the high-boiling-point organic solvent is used, the contained amount is preferably 1 to 30 parts by mass per 100 parts by mass of the organic solvent having a boiling point lower than 180°C. When the contained amount is as described, sufficient thermal flowability can be imparted at the time of baking and the solvent does not remain in the film and cause degradation in the physical properties, such as etching resistance, of the film. Therefore, such an amount is preferable.

### [(C) Thermal Acid Generator]

In the inventive composition for forming a metal-containing film, a thermal acid generator (C) is preferably contained to promote a crosslinking reaction by heat.

Examples of a thermal acid generator (C) usable in the inventive composition for forming a metal-containing film include the following general formula (7') etc.

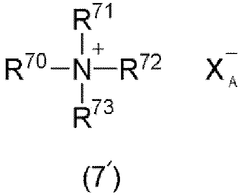

In the formula, X_{A}⁻ represents a non-nucleophilic counter ion. R⁷⁰, R⁷¹, R⁷², and R⁷³ each represent a hydrogen atom, a linear, branched, or cyclic alkyl group, alkenyl group, oxoalkyl group, or oxoalkenyl group, having 1 to 12 carbon atoms, an aryl group having 6 to 20 carbon atoms, or an aralkyl group or aryloxoalkyl group having 7 to 12 carbon atoms, part or all of the hydrogen atoms of these groups optionally being substituted with an alkoxy group or the like. In addition, R⁷⁰ and R⁷¹, or R⁷⁰, R⁷¹, and R⁷² optionally form a ring, and in a case where a ring is formed, R⁷⁰ and R⁷¹, or R⁷⁰, R⁷¹, and R⁷² represent an alkylene group having 3 to 10 carbon atoms, or a heteroaromatic ring having the nitrogen atom in the formula in the ring.

The R⁷⁰, R⁷¹, R⁷², and R⁷³ may be identical to or different from each other, and specific examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, etc.

Examples of the alkenyl group include a vinyl group, an allyl group, a propenyl group, a butenyl group, a hexenyl group, a cyclohexenyl group, etc.

Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, etc.

Examples of the oxoalkenyl group include a 2-oxo-4-cyclohexenyl group, a 2-oxo-4-propenyl group, etc.

Examples of the aryl group include a phenyl group; a naphthyl group; alkoxyphenyl groups, such as a p-methoxyphenyl group, an m-methoxyphenyl group, an o-methoxyphenyl group, an ethoxyphenyl group, a p-tert-butoxyphenyl group, and an m-tert-butoxyphenyl group; alkyl phenyl groups, such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups, such as a methylnaphthyl group and an ethylnaphthyl group; alkoxynaphthyl groups, such as a methoxynaphthyl group and an ethoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group; etc.

Examples of the aralkyl group include a benzyl group, a phenylethyl group, a phenethyl group, etc.

Examples of the aryloxoalkyl group include 2-aryl-2-oxoethyl groups such as a 2-phenyl-2-oxoethyl group, a 2-(1-naphthyl)-2-oxoethyl group, a 2-(2-naphthyl)-2-oxoethyl group, etc.

When R⁷⁰ and R⁷¹, or R⁷⁰, R⁷¹, and R⁷² form a heteroaromatic ring having, in the ring, the nitrogen atom in the formula, examples include imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

Examples of the non-nucleophilic counter ion of X_{A}⁻include halide ions, such as chloride ion and bromide ion; fluoroalkylsulfonates, such as triflate, 1,1,1-trifluoroethanesulfonate, and nonafluorobutanesulfonate; arylsulfonates, such as tosylate, benzenesulfonate, 4-fluorobenzenesulfonate, and 1,2,3,4,5-pentafluorobenzenesulfonate; alkylsulfonates, such as mesylate and butanesulfonate; imidic acids, such as bis(trifluoromethylsulfonyl)imide, bis(perfluoroethylsulfonyl)imide, and bis(perfluorobutylsulfonyl)imide; methide acids, such as tris(trifluoromethylsulfonyl)methide and tris(perfluoroethylsulfonyl)methide; furthermore, sulfonates, represented by the following general formula (8), being fluorinated in the α-position; and sulfonates, represented by the following general formula (9), being fluorinated in the α- and β-positions.

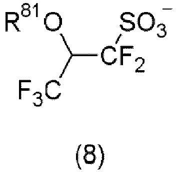

R⁹¹CF₂CF₂SO₃⁻ (9)

In the general formula (8), R⁸¹ represents a hydrogen atom, a linear, branched, or cyclic alkyl group or acyl group having 1 to 23 carbon atoms, an alkenyl group having 2 to 20 carbon atoms, or an aryl group or aryloxy group having 6 to 20 carbon atoms. In the general formula (9), R⁹¹ represents a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the thermal acid generator include the following, but are not limited thereto.

(CH₃CH₂)₅N⁺H (CH₃CH₂)₃N⁺H (CH₃CH₂)₃N⁺H (CH₃CH₂)₃N⁺H (CH₃CH₂)₅N⁺H C₄F₉SO₃⁻ 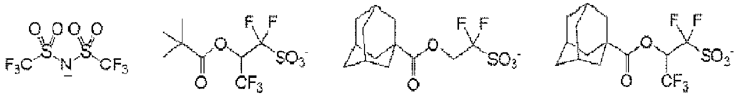 (CH₃CH₂)₃N⁺H (CH₃CH₂)₃N⁺H (CH₃CH₃)₃N⁺H

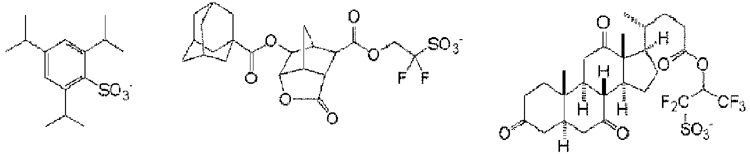

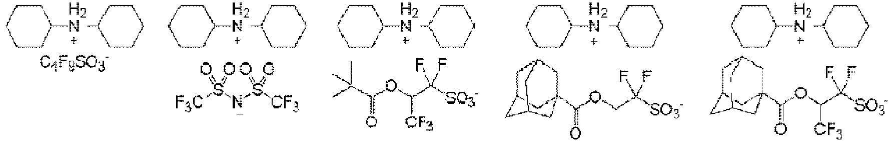

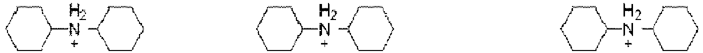

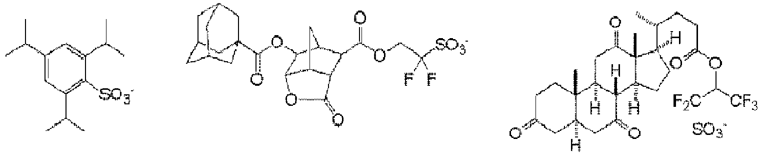

One kind of the thermal acid generator (C), contained in the inventive composition for forming a metal-containing film, may be used, or two or more kinds thereof may be used in combination. The thermal acid generator (C) is preferably contained in an amount of 0.05 to 30 parts by mass, more preferably 0.1 to 10 parts by mass based on 100 parts by mass of the compound (A) for forming a metal-containing film. When the amount is 0.05 parts by mass or more, the amount of generated acid and crosslinking reaction are sufficient, and when 30 parts by mass or less, a mixing phenomenon due to an acid moving to an upper layer resist does not occur.

### [(D) Photo-Acid Generator]

The inventive composition for forming a metal-containing film can contain a photo-acid generator (D) for adjusting appropriately a pattern profile in a resist upper layer film, exposure sensitivity, etc. One kind of the photo-acid generator (D) may be used, or two or more kinds thereof may be used in combination. As the photo-acid generator (D), for example, those disclosed in paragraphs [0160] to [0179] of JP2009-126940A can be used. The photo-acid generator (D) is preferably contained in an amount of 0.05 to 30 parts by mass, more preferably 0.1 to 10 parts by mass based on 100 parts by mass of the compound (A) for forming a metal-containing film. When the photo-acid generator is contained in the above-described ranges, resolution is excellent, and no problems of foreign substances occur after developing a resist or when removing the resist.

### [(E) Crosslinking Agent]

The inventive composition for forming a metal-containing film can also contain a crosslinking agent (E) to increase curability and further inhibit intermixing with a resist upper layer film. The crosslinking agent (E) is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (E) can be used, or two or more kinds thereof can be used in combination, and when the crosslinking agent (E) is contained, the contained amount is preferably 5 to 50 parts by mass, more preferably 10 to 40 parts by mass based on 100 parts by mass of the compound (A) for forming a metal-containing film. When the contained amount is 5 parts by mass or more, sufficient curability can be exhibited, and intermixing with a resist upper layer film can be suppressed. Meanwhile, when the contained amount is 50 parts by mass or less, there is no risk of degradation in dry etching resistance due to the proportion of the compound (A) for forming a metal-containing film in the composition being low.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis(4,5-diphenyl-2-oxazoline), 2,2'-methylene bis(4-phenyl-2-oxazoline), 2,2'-methylene bis(4-tert-butyl-2-oxazoline), 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

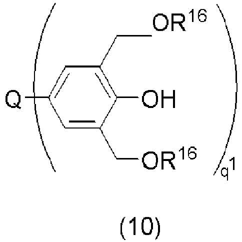

In the formula, Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

Q represents a single bond or a q¹-valent hydrocarbon group having 1 to 20 carbon atoms. "q¹" represents an integer of 1 to 5, more preferably 2 or 3. Specific examples of Q include groups obtained by removing "q¹" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compounds represented by the general formula (10) include the following compounds. Among these, a hexamethoxymethylated derivative of triphenolmethane, triphenolethane, 1,1,1,-tris(4-hydroxyphenyl)ethane, and tris(4-hydroxyphenyl)-1-ethyl-4-isopropylbenzene are preferable from the viewpoint of improving the curability and film thickness uniformity of the metal-containing film.

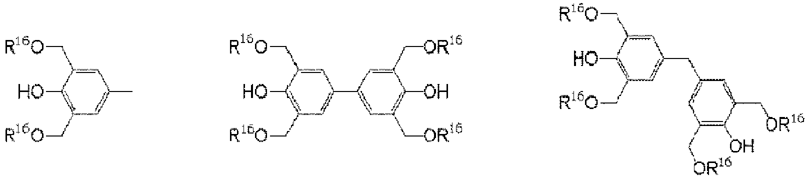

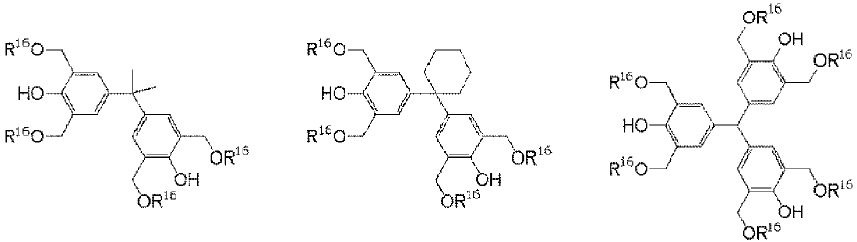

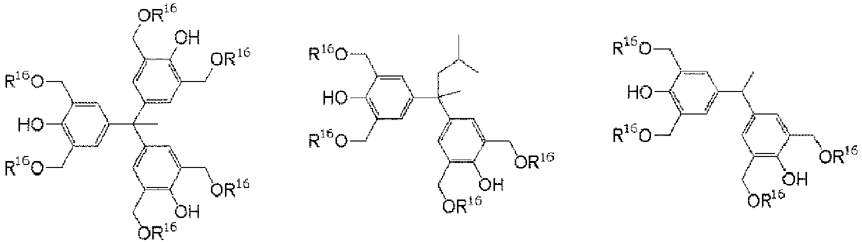

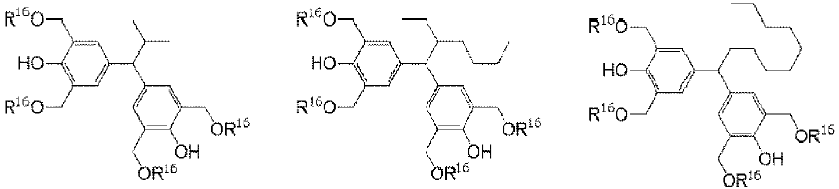

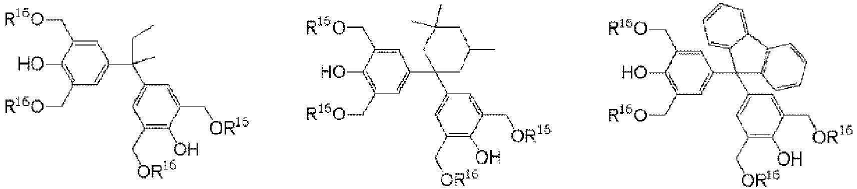

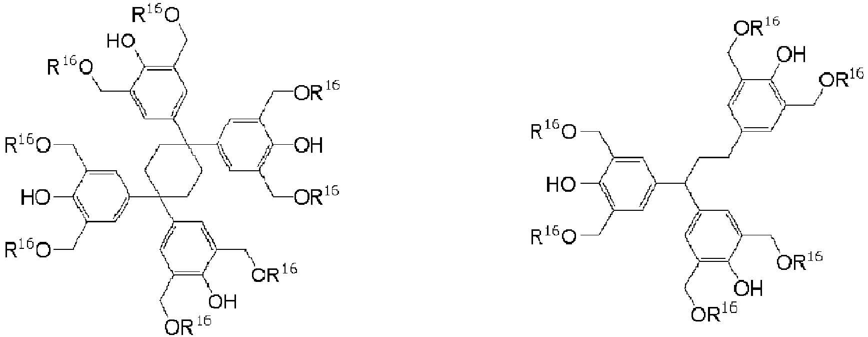

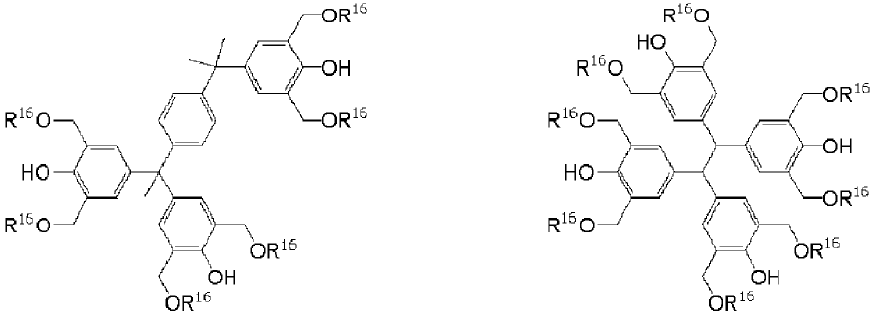

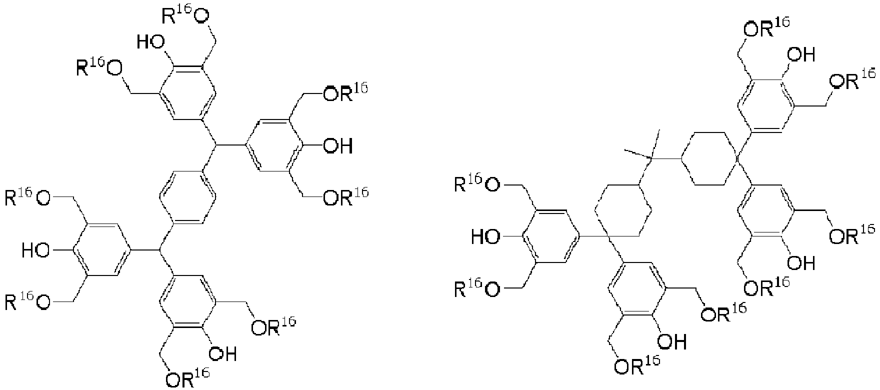

### [(G) Surfactant]

A surfactant (G) may be contained in the inventive composition for forming a metal-containing film in order to improve coating property in spin-coating. One surfactant (G) can be used, or two or more surfactants (G) can be used in combination. Examples of the surfactant (G) include those disclosed in paragraphs [0142] to [0147] of JP2009-269953A. When the surfactant (G) is contained, the contained amount is preferably 0.001 to 20 parts by mass, more preferably 0.01 to 10 parts by mass per 100 parts by mass of the compound (A) for forming a metal-containing film. When the amount is in such a range, coating property is certainly improved, and a thin, uniform, metal-containing film can be formed.

### [Plasticizer]

The inventive composition for forming a metal-containing film can also contain a plasticizer. The plasticizer is not particularly limited, and various known plasticizers can be widely used. Examples include: low molecular-weight compounds, such as phthalate esters, adipate esters, phosphate esters, trimellitate esters, and citrate esters; and polymers, such as polyether polymers, polyester polymers, and polyacetal polymers described in JP2013-253227A. The amount of the plasticizer to be contained is preferably 1 mass% to 500 mass% based on 100 parts by mass of the compound (A) for forming a metal-containing film. When the contained amount is in such a range, the composition is excellent in filling and planarizing of a pattern.

### <Method for Forming Metal-Containing Film>

In the present invention, by using the above-described composition for forming a metal-containing film, it is possible to form, for example, a metal-containing film as a resist underlayer film of a multilayer resist film used in lithography.

In the method for forming a metal-containing film by using the inventive composition for forming a metal-containing film, a substrate to be processed is coated with the above-described composition for forming a metal-containing film by a spin-coating method or the like. After spin-coating, baking (heating) is performed so as to evaporate the solvent and promote a crosslinking reaction to prevent mixing with a resist upper layer film. The baking is preferably performed at a temperature of 100°C or higher and 450°C or lower for 10 to 600 seconds, more preferably at 200°C or higher and 300°C or lower for 10 to 300 seconds. In consideration of influences on device damage, wafer deformation, and the like, the upper limit of the heating temperature in the wafer process of lithography is preferably not more than 450°C, and more preferably not more than 300°C.

In the method for forming a metal-containing film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By virtue of baking the inventive composition for forming a metal-containing film in such an oxygen atmosphere, a sufficiently cured metal-containing film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1,000 ppm or less, more preferably 100 ppm or less (volumetric basis). By thus preventing oxidation of the metal-containing film during the baking, the absorption does not increase and the etching resistance does not decrease, which is preferable.

Alternatively, using the above-described composition for forming a metal-containing film, it is also possible to form, for example, a metal-containing film as a resist middle layer film of a multilayer resist film used in lithography.

### [Patterning Process Using Composition for Forming Metal-Containing Film]

The present invention provides, as a patterning process according to a two-layer resist process using the inventive composition for forming a metal-containing film, a patterning process for forming a pattern in a substrate to be processed, including the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the transferred pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas. The metal-containing film exhibits etching resistance with respect to fluorine-based gas. Therefore, the dry etching of the substrate to be processed that is performed while using the metal-containing film as a mask is preferably performed using an etching gas mainly containing a fluorine-based gas.

The present invention also provides, as a patterning process according to a three-layer resist process using the inventive composition for forming a metal-containing film, a patterning process for forming a pattern in a substrate to be processed, including the steps of:
(II-1) forming a resist underlayer film on a substrate to be processed;
(II-2) applying the above-described composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the transferred pattern as a mask to form the pattern in the substrate to be processed.

The metal-containing film, formed with the inventive composition for forming a metal-containing film, used as the resist middle layer film in the above-described three-layer resist process exhibits etching resistance with respect to oxygen-based gas. Therefore, the dry etching of the resist underlayer film that is performed while using the metal-containing film as a mask in the three-layer resist process is preferably performed using an etching gas mainly containing an oxygen-based gas. The resist underlayer film exhibits etching resistance with respect to fluorine-based gas. Therefore, the dry etching of the substrate to be processed that is performed while using the resist underlayer film as a mask is preferably performed using an etching gas mainly containing a fluorine-based gas.

In the above-described patterning process, the resist upper layer film may be either a positive type or a negative type, and it is possible to use a composition similar to the typically used photoresist composition. In a case where the resist upper layer film is formed with the photoresist composition, a spin-coating method is preferable.

In a case where the resist upper layer film is formed by a spin-coating method using a photoresist composition, prebaking is conducted after applying the photoresist composition. The prebaking is preferably performed at 60 to 180°C for 10 to 300 seconds. Thereafter, exposure is conducted according to a usual manner, followed by post-exposure baking (PEB) and development, and thereby, a resist upper layer film pattern can be obtained. Although the thickness of the resist upper layer film is not particularly limited, the thickness is preferably 10 to 500 nm, particularly preferably 20 to 400 nm.

Examples of the light for exposure include high-energy beams at wavelengths of 300 nm or less, specifically, far ultraviolet rays, KrF excimer laser beam (248 nm), ArF excimer laser beam (193 nm), F₂ laser beam (157 nm), Kr₂ laser beam (146 nm), Ar₂ laser beam (126 nm), soft X-rays at 3 to 20 nm (EUV), electron beam (EB), ion beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist upper layer film pattern as a mask. For example, the etching of the metal-containing film in the two-layer resist process is performed by using a chlorine-based gas while using the resist upper layer film pattern as a mask. In this manner, a metal-containing film pattern is formed. Next, the substrate to be processed is etched while using the obtained metal-containing film pattern as a mask. The etching of a body to be processed may be performed according to a usual manner. For example, in the case of a body to be processed made of SiO₂, SiN or silica-based low dielectric constant insulating film, the etching is performed mainly based on a fluorocarbon-based gas.

The metal-containing film obtained by using the inventive composition for forming a metal-containing film is characterized by its excellent etching resistance at the time of etching of the body to be processed.

As a resist underlayer film material that can be used for the above-described resist underlayer film, examples include materials already known as materials for an underlayer film for a three-layer resist method or a two-layer resist method using a silicon resist composition. Examples include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

The resist underlayer film can be formed on the substrate to be processed, for example, by using a composition solution containing the above-described resist underlayer film material and by a spin-coating method or the like in the same manner as the photoresist composition. After forming the resist underlayer film by a spin-coating method or the like, it is desirable to bake the film in order to evaporate the organic solvent. The baking temperature is preferably 100 to 600°C, and the baking time is preferably 10 to 300 seconds.

Instead of the resist underlayer film material, it is also possible to adopt an organic hard mask formed by a CVD method or an ALD method.

In the case of the three-layer resist process, the dry etching of the metal-containing film is performed, for example, by using a chlorine-based gas while using the resist upper layer film pattern as a mask. In this manner, the metal-containing film pattern is formed. Next, the resist underlayer film is etched by using an oxygen-based gas while using the obtained metal-containing film pattern as a mask. In this manner, the resist underlayer film pattern is formed. Next, the substrate to be processed is etched while using the obtained resist underlayer film pattern as a mask.

The metal-containing film obtained by using the inventive composition for forming a metal-containing film is characterized by its excellent etching resistance at the time of etching of the resist underlayer film.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films, such as those made of Si, SiO₂, SiON, SiN, p-Si, α-Si, W, W-Si, Al, Cu, Al-Si, and the like; and stopper films therefor, which can each be typically formed into a thickness of 50 to 10,000 nm, particularly 100 to 5,000 nm. When the layer to be processed is formed, the substrate and the layer to be processed are made of different materials.

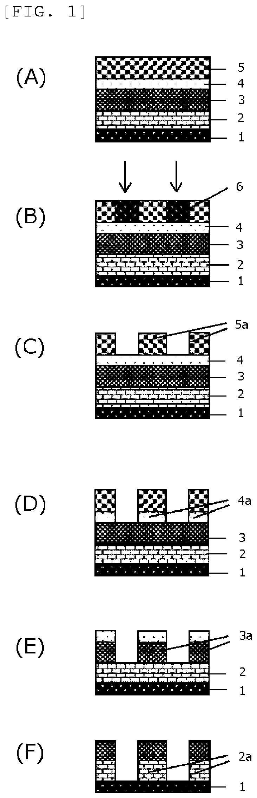

Here, with reference to FIG. 1, an example of a patterning process according to the above-described three-layer resist process will be described. In this example, firstly, a resist underlayer film 3 is formed on a layer 2 to be processed of a substrate to be processed, including a substrate 1 and the layer 2 to be processed thereon, by using a resist underlayer film material, a metal-containing film 4 is formed on the resist underlayer film 3 by using the inventive composition for forming a metal-containing film, and a resist upper layer film 5 is formed on the metal-containing film 4 by using a photoresist material, as in FIG. 1 (A). Subsequently, an exposure portion 6 of the resist upper layer film is subjected to pattern exposure as in FIG. 1 (B). Then, development is performed with a developer to form a resist upper layer film pattern 5a in the resist upper layer film as in FIG. 1 (C). Next, the pattern is transferred to the metal-containing film by dry etching while using the resist upper layer film having the formed resist upper layer film pattern 5a as a mask to obtain a metal-containing film pattern 4a as in FIG. 1 (D). Subsequently, the pattern is transferred to the resist underlayer film by dry etching while using the metal-containing film having the formed metal-containing film pattern 4a as a mask to obtain a resist underlayer film pattern 3a as in FIG. 1 (E). Then, the layer 2 to be processed on the substrate 1 is processed while using the resist underlayer film having the formed pattern 3a as a mask to form a pattern 2a in the substrate to be processed as in FIG. 1 (F).

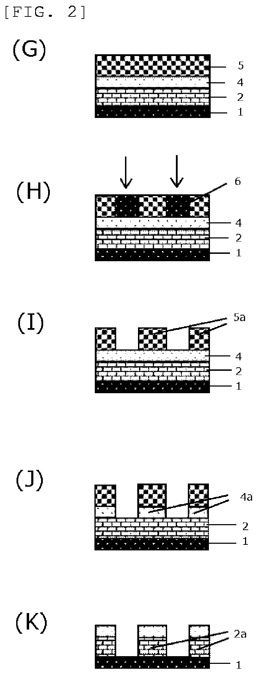

With reference to FIG. 2, an example of a patterning process according to the above-described two-layer resist process will be described. In this example, firstly, a metal-containing film 4 is formed on a layer 2 to be processed of a substrate to be processed, including a substrate 1 and the layer 2 to be processed thereon, by using the inventive composition for forming a metal-containing film, and a resist upper layer film 5 is formed on the metal-containing film 4 by using a photoresist material, as in FIG. 2 (G). Subsequently, an exposure portion 6 of the resist upper layer film is subjected to pattern exposure as in FIG. 2 (H). Then, development is performed with a developer to form a resist upper layer film pattern 5a in the resist upper layer film as in FIG. 2 (I). Next, the pattern is transferred to the metal-containing film by dry etching while using the resist upper layer film having the formed pattern 5a as a mask to obtain a metal-containing film pattern 4a as in FIG. 2 (J). Then, the layer 2 to be processed on the substrate 1 is processed while using the metal-containing film having the formed metal-containing film pattern 4a as a mask to form a pattern 2a in the substrate to be processed as in FIG. 2 (K).

### EXAMPLES

The present invention is further specifically described below with reference to Synthesis Examples, Comparative Synthesis Examples, Examples, and Comparative Examples. However, the present invention is not limited to these Examples.

### [Synthesis of Compound (A) for Forming Metal-Containing Film]

In the following Synthesis Examples, the following organic group starting material group G ((G1) to (G10)) and silicon-containing organic group starting material group H ((H1) and (H2)) were used.

The organic group starting material group G ((G1) to (G10)) and the silicon-containing organic group starting material group H ((H1) and (H2)) are shown below.

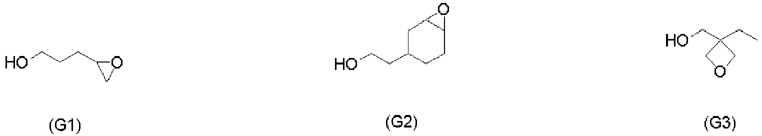

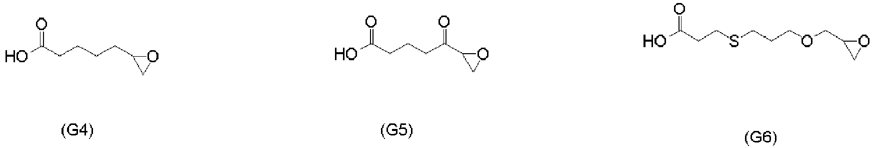

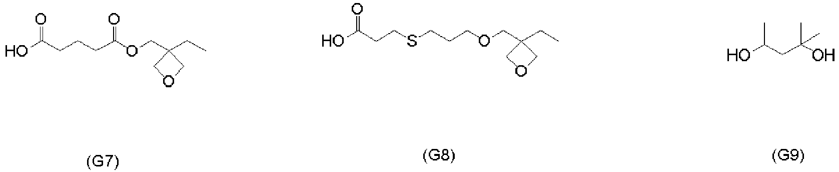

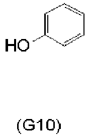

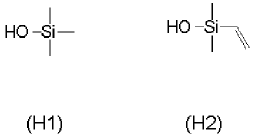

As a metal source M, the following metal compounds were used.
(M1): titanium tetraisopropoxide (377996 available from Sigma-Aldrich Corp)
(M2): Hf(OBu)₄: hafnium(IV) n-butoxide (667943 available from Sigma-Aldrich Corp)
(M3): Zr(OBu)₄: zirconium(IV) tetrabutoxide (80 mass% solution in 1-butanol) (Z0016 available from Tokyo Chemical Industry Co., Ltd.)

### [Synthesis Example 1] Synthesis of Compound (A-1) for Forming Metal-Containing Film

Under a nitrogen atmosphere, 28.4 g of titanium tetraisopropoxide (M1) was dissolved in 50.0 g of 2-propanol, and while stirring, 50.0 g of a solution of 2.7 g of deionized water in IPA was added dropwise at room temperature over 2 hours. To the obtained solution, 10.0 g of the organic group starting material (G1) was added, and the mixture was agitated at room temperature for 30 minutes. After the solution was concentrated under reduced pressure at 30°C, it was further heated to 60°C and heating was continued under reduced pressure to generate no distillate. When distillates were no longer observed, 120.0 g of a PGMEA/PGME (ratio by mass: 70/30) solution was added thereto and heated under reduced pressure at 40°C until no IPA was distilled. Thus, a solution of a compound (A-1) for forming a metal-containing film in PGMEA/PGME was obtained.

### [Synthesis Examples 2 to 8] Synthesis of Compounds (A-2) to (A-8) for Forming Metal-Containing Film

The compounds (A-2) to (A-8) for forming a metal-containing film shown in Table 1 were obtained under the same reaction conditions as in Synthesis Example 1, except that the metal source M and the organic group starting material group G were used at the charging amounts shown in Table 1.

**[Table 1]**

| Synthesis Example | Metal source M | | Organic group starting material group G | | Compound |
|---|---|---|---|---|---|
| | Starting material | g | Starting material | g | |
| 1 | M1 | 28.4 | G1 | 10.0 | A-1 |
| 2 | M2 | 47.9 | G2 | 14.0 | A-2 |
| 3 | M3 | 48.5 | G3 | 12.0 | A-3 |
| 4 | M3 | 47.9 | G4 | 20.0 | A-4 |
| 5 | M3 | 47.9 | G5 | 21.0 | A-5 |
| 6 | M3 | 47.9 | G6 | 30.0 | A-6 |
| 7 | M3 | 47.9 | G7 | 31.0 | A-7 |
| 8 | M3 | 47.9 | G8 | 35.0 | A-8 |

### [Synthesis Example 9] Synthesis of Compound (A-9) for Forming Metal-Containing Film

Under a nitrogen atmosphere, 15.0 g of zirconium(IV) tetrabutoxide (M3) was dissolved in 20.6 g of a PGMEA/PGME (ratio by mass: 70/30) solution. The reaction temperature was raised to 50°C while stirring, and 9.0 g of the silicon-containing organic group starting material (H1) was added dropwise to the solution. After the addition, stirring was continued for 2 hours at a reaction temperature of 60°C. Subsequently, a mixture obtained by suspending 7.0 g of the organic group starting material (G3) in 8.6 g of a PGMEA/PGME (ratio by mass: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-9) for forming a metal-containing film in PGMEA/PGME was obtained.

### [Synthesis Examples 10 and 11 and Comparative Synthesis Examples 1 and 2] Synthesis of Compounds (A-10) and (A-11) for Forming Metal-Containing Film and Comparative Compounds (R-1) and (R-2)

The compounds (A-10) and (A-11) for forming a metal-containing film and the comparative compounds (R-1) and (R-2) shown in Table 2 were obtained under the same reaction conditions as in Synthesis Example 9, except that the metal source M, the organic group starting material group G, and the silicon-containing organic group starting material group H were used at the charging amounts shown in Table 2.

**[Table 2]**

| Synthesis Example | Metal source M | | Organic group starting material group G | | Silicon-containing organic group starting material group H | | Compound |
|---|---|---|---|---|---|---|---|
| | Starting material | g | Starting material | g | Starting material | g | |
| 9 | M3 | 15.0 | G3 | 7.0 | H1 | 9.0 | A-9 |
| 10 | M3 | 15.0 | G7 | 14.0 | H2 | 9.0 | A-10 |
| 11 | M3 | 15.0 | G8 | 16.0 | H1 | 9.0 | A-11 |
| Comparative Synthesis Example 1 | M3 | 15.0 | G9 | 8.0 | H1 | 9.0 | R-1 |
| Comparative Synthesis Example 2 | M3 | 15.0 | G10 | 6.0 | H1 | 9.0 | R-2 |

### Preparation of Compositions (MUL-1 to -16 and Comparative MUL-1 and -2) for Forming Metal-Containing Film

For the preparation of compositions for forming a metal-containing film, the following were used: the compounds (A-1) to (A-11) for forming a metal-containing film and the comparative compounds (R-1) and (R-2); (AG1) as a thermal acid generator; (AG2) as a photo-acid generator; (XL1) and (XL2) as crosslinking agents; and (F1: ethylene glycol dibenzyl ether, having a boiling point of 364°C) as a high-boiling-point solvent. These were dissolved in an organic solvent containing 0.001 mass% of PF636 (available from OMNOVA Solutions Inc.) in proportions shown in Table 3, and then the solution was filtered through a 0.1-pm filter made of a fluororesin to prepare each of the compositions (MUL-1 to -16 and comparative MUL-1 and -2) for forming a metal-containing film.

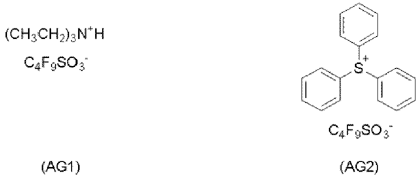

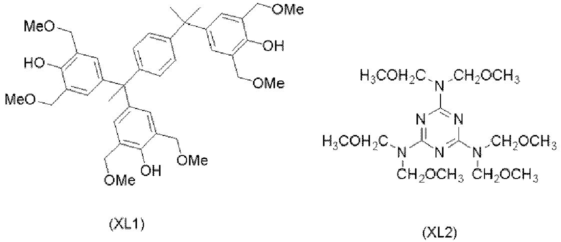

**[Table 3]**

| Composition for forming metal-containing film | (A) Compound for forming metal-containing film | Thermal acid generator | Photo-acid generator | Crosslinking agent | High-boiling-point solvent | Solvent |
|---|---|---|---|---|---|---|
| | (parts by mass) | (parts by mass) | (parts by mass) | (parts by mass) | (parts by mass) | (parts by mass) |
| MUL-1 | A-1 (5) | | - | - | - | PGMEA/PGME(65/30) |
| MUL-2 | A-2 (5) | | - | - | - | PGMEA/PGME(65/30) |
| MUL-3 | A-3 (5) | | - | - | - | PGMEA/PGME(65/30) |
| MUL-4 | A-4 (3) | | - | - | - | PGMEA/PGME(67/30) |
| MUL-5 | A-5 (3) | | - | - | - | PGMEA/PGME(67/30) |
| MUL-6 | A-6 (3) | | - | - | - | PGMEA/PGME(67/30) |
| MUL-7 | A-7 (3) | | - | - | - | PGMEA/PGME(67/30) |
| MUL-8 | A-8 (3) | | - | - | - | PGMEA/PGME(67/30) |
| MUL-9 | A-9 (3) | | - | - | - | PGMEA/PGME(67/30) |
| MUL-10 | A-10 (3) | | - | - | - | PGMEA/PGME(67/30) |
| MUL-11 | A-11 (3) | | | - | - | PGMEA/PGME(67/30) |
| MUL-12 | A-3 (5) | AG1 (0.2) | AG2 (0.2) | - | - | PGMEA/PGME(65/30) |
| MUL-13 | A-3 (5) | | | - | - | PGMEA/PGME(65/30) |
| MUL-14 | A-3 (5) | | - | XL1 (0.5) | - | PGMEA/PGME(65/30) |
| MUL-15 | A-3 (5) | AG1 (0.2) | - | XL2 (0.5) | | PGMEA/PGME(65/30) |
| MUL-16 | A-3 (5) | | - | - | F1 (5) | PGMEA/PGME(65/30) |
| Comparative MUL-1 | R-1 (3) | - | - | - | - | PGMEA/PGME(67/30) |
| Comparative MUL-2 | R-2 (3) | - | - | - | - | PGMEA/PGME(67/30) |

### [Solvent Resistance Evaluation and Contact Angle Evaluation (Examples 1-1 to 1-16 and Comparative Examples 1-1 and 1-2)]

Each of the compositions (MUL-1 to -16 and comparative MUL-1 and -2) for forming a metal-containing film prepared above was respectively applied onto a silicon substrate, baked at the temperature shown in Table 4 for 60 seconds, then the thickness of the film from the center of the substrate to the periphery was measured, and the average film thickness (a [nm]) was calculated. Subsequently, a PGMEA solvent was dispensed thereon, left to stand for 30 seconds, then spin-drying was performed, then the PGMEA was evaporated by baking at 100°C for 60 seconds, and the film thickness (b [nm]) was measured. The difference between the film thicknesses of before and after the PGMEA treatment (film remaining percentage: (b/a) × 100) was calculated.

In addition, regarding each of the cured films, a contact angle (CA1) with pure water was measured.

The results are shown in Table 4 below.

**[Table 4]**

| Example | Composition for forming metal-containing film | Baking temperature | Film thickness after film formation: a | Film thickness after solvent treatment: b | b/a × 100 | Contact angle (CA1) |
|---|---|---|---|---|---|---|
| | | | Å | Å | % | deg. |
| Example 1-1 | MUL-1 | 350°C | 450.4 | 450.3 | 100% | 68 |
| Example 1-2 | MUL-2 | 350°C | 466.9 | 466.7 | 100% | 65 |
| Example 1-3 | MUL-3 | 350°C | 471.4 | 470.3 | 100% | 70 |
| Example 1-4 | MUL-4 | 250°C | 482.4 | 482.3 | 100% | 62 |
| Example 1-5 | MUL-5 | 250°C | 476.4 | 476.4 | 100% | 63 |
| Example 1-6 | MUL-6 | 250°C | 469.3 | 469.2 | 100% | 63 |
| Example 1-7 | MUL-7 | 250°C | 463.5 | 463.4 | 100% | 68 |
| Example 1-8 | MUL-8 | 250°C | 458.7 | 458.8 | 100% | 63 |
| Example 1-9 | MUL-9 | 350°C | 486.3 | 486.4 | 100% | 72 |
| Example 1-10 | MUL-10 | 250°C | 482.3 | 482.2 | 100% | 73 |
| Example 1-11 | MUL-11 | 250°C | 477.6 | 477.5 | 100% | 66 |
| Example 1-12 | MUL-12 | 350°C | 470.2 | 470.2 | 100% | 74 |
| Example 1-13 | MUL-13 | 350°C | 468.5 | 468.5 | 100% | 71 |
| Example 1-14 | MUL-14 | 350°C | 447.9 | 447.8 | 100% | 71 |
| Example 1-15 | MUL-15 | 350°C | 453.2 | 453.1 | 100% | 76 |
| Example 1-16 | MUL-16 | 350°C | 432.6 | 432.5 | 100% | 70 |
| Comparative Example 1-1 | Comparative MUL-1 | 250°C | 468.2 | 468.1 | 100% | 35 |
| Comparative Example 1-2 | Comparative MUL-2 | 250°C | 460.3 | 460.3 | 100% | 50 |

As shown in Table 4, it can be observed that in Examples 1-1 to 1-16, using the inventive compositions (MUL-1 to -16) for forming a metal-containing film, the compositions all had excellent film-formability and underwent hardly any film loss due to the solvent treatment, and achieved films having excellent solvent resistance. In addition, the films had a contact angle of over 60° to pure water by containing one of the groups represented by the formulae (a-1) to (a-3), and it can be seen that excellent adhesiveness to a resist pattern can be expected. It was also found that the contact angle was particularly high in Examples 1-12 and 1-15, where a composition containing the thermal acid generator (AG1) was used. It is conjectured that this is because curing caused by the ring-opening reaction of the epoxy or oxetane structure was promoted by the action of the acid generator, although the effect is uncertain.

On the other hand, in Comparative Examples 1-1 and 1-2, using the compositions (comparative MUL-1 and -2), which are not the inventive composition for forming a metal-containing film, a film having excellent solvent resistance was obtained, but the contact angle to pure water was less than 60°.

### [Optical Constant (n/k) Evaluation (Examples 2-1 to 2-14 and Comparative 2-1 and 2-2)]

Each of the compositions (MUL-3 to -16 and comparative MUL-1 and -2) for forming a metal-containing film was respectively applied onto a silicon substrate, baked at the temperature shown in Table 5 for 60 seconds, and then the optical constants (refractive index "n" and attenuation coefficient "k") at a wavelength of 193 nm were determined by using a spectroscopic ellipsometer (VASE) with variable angle of incidence manufactured by J. A. Woollam Japan. The results are shown together in Table 5.

**[Table 5]**

| Example | Composition for forming metal-containing film | Baking temperature | n | k |
|---|---|---|---|---|
| | | | 193 nm | 193 nm |
| Example 2-1 | MUL-3 | 350°C | 1.91 | 0.19 |
| Example 2-2 | MUL-4 | 250°C | 1.90 | 0.20 |
| Example 2-3 | MUL-5 | 250°C | 1.88 | 0.21 |
| Example 2-4 | MUL-6 | 250°C | 1.87 | 0.22 |
| Example 2-5 | MUL-7 | 250°C | 1.89 | 0.22 |
| Example 2-6 | MUL-8 | 250°C | 1.90 | 0.21 |
| Example 2-7 | MUL-9 | 350°C | 1.92 | 0.22 |
| Example 2-8 | MUL-10 | 250°C | 1.91 | 0.23 |
| Example 2-9 | MUL-11 | 250°C | 1.90 | 0.23 |
| Example 2-10 | MUL-12 | 350°C | 1.91 | 0.19 |
| Example 2-11 | MUL-13 | 350°C | 1.91 | 0.19 |
| Example 2-12 | MUL-14 | 350°C | 1.88 | 0.21 |
| Example 2-13 | MUL-15 | 350°C | 1.91 | 0.23 |
| Example 2-14 | MUL-16 | 350°C | 1.91 | 0.19 |
| Comparative Example 2-1 | Comparative MUL-1 | 250°C | 2.10 | 0.30 |
| Comparative Example 2-2 | Comparative MUL-2 | 250°C | 2.05 | 0.33 |

As shown in Table 5, in Examples 2-1 to 2-14, where the inventive compositions (MUL-3 to -16) for forming a metal-containing film were used, the "n" value was 1.8 to 2.3 and the "k" value was 0.1 to 0.5 in every case.

The optical constants also depend on the film thickness, the type of the resist upper layer film, etc., but as long as the "n" value is approximately between 1.8 and 2.3 and the "k" value is approximately between 0.1 and 0.5, light reflected from the substrate in ArF immersion and high-NA exposure can be considerably suppressed even when the metal-containing film is formed as a thin film of 20 nm or less, and the metal-containing film is applicable as a resist underlayer film for photoresist patterning. In the above-described Examples, the optical constants are in suitable ranges in every case, and it can be seen that the films are applicable as resist underlayer films in photoresist patterning.

### [Etching Resistance Evaluation (Examples 3-1 to 3-16 and Comparative Examples 3-1 to 3-4)]

Each of the compositions (MUL-1 to -16 and comparative MUL-1 and -2) for forming a metal-containing film was respectively applied onto a silicon substrate and heated by using a hot plate at the same temperature as that shown in Table 4 for 60 seconds to form a metal-containing film having a film thickness of 50 nm (film thickness "a").

In Comparative Example 3-3, the following silicon-containing resist middle layer film composition (SOG-1) was applied and baked at 220°C for 60 seconds to form a resist middle layer film having a film thickness of 50 nm (film thickness "a").

The silicon-containing resist middle layer film composition (SOG-1) was prepared by dissolving an ArF silicon-containing resist middle layer film polymer represented by (SiP1) and a thermal crosslinking catalyst (CAT1) in a solvent containing 0.1 mass% of FC-4430 (available from Sumitomo 3M Limited) in the proportion shown in Table 6; and filtering the solution through a filter made of a fluororesin and having a pore size of 0.1 µm.

**[Table 6]**

| | Polymer | Thermal crosslinking catalyst | Solvent 1 | Solvent 2 |
|---|---|---|---|---|
| | (parts by mass) | (parts by mass) | (parts by mass) | (parts by mass) |
| SOG-1 | SiP1 | CAT1 | Propylene glycol monoethyl ether | Pure water |
| | (100) | (1) | (2,900) | (400) |

The structural formulae of the used ArF silicon-containing resist middle layer film polymer (SiP1) and thermal crosslinking catalyst (CAT1) are shown below.

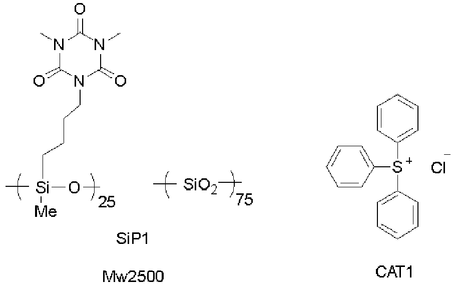

In Comparative Example 3-4, the following organic resist underlayer film composition (SOC-1) was applied and baked at 350°C for 60 seconds to form a resist underlayer film having a film thickness of 50 nm (film thickness "a").

The organic resist underlayer film composition (SOC-1) was prepared by dissolving an organic resist underlayer film polymer represented by (CP1) in a solvent containing 0.1 mass% of FC-4430 (available from Sumitomo 3M Limited) in the proportion shown in Table 7; and filtering the solution through a filter made of a fluororesin and having a pore size of 0.1 µm.

**[Table 7]**

| | Polymer | Solvent 1 |
|---|---|---|
| | (parts by mass) | (parts by mass) |
| SOC-1 | CP1 | Propylene glycol monoethyl ether |
| | (100) | (3,000) |

The structural formula of the used organic resist underlayer film polymer (CP1) is shown below. 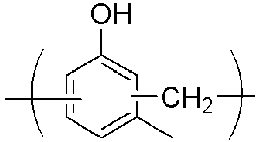 Mw=7,000, Mw/Mn=3.50

Subsequently, using an etching apparatus CE-300I manufactured by ULVAC, Inc., etching using a CF₄ gas and O₂ gas was each performed under the following conditions, and the film thickness "b" was measured. Then, the film thickness etched in one minute was calculated as an etching rate (nm/min) from the film thickness etched (film thickness "a" - film thickness "b") using the respective gas in a specified time, and etching resistance was evaluated.

When the etching rate to CF₄ gas was lower than 20 nm/min, the evaluation "A (very good)" was given, when 20 nm/min to 30 nm/min, "B (good)", and when over 30 nm/min, "C (poor)".

When the etching rate to O₂ gas was lower than 20 nm/min, the evaluation "A (very good)" was given, when 20 nm/min to 30 nm/min, "B (good)", and when over 30 nm/min, "C (poor)".

Table 8 shows the results.

### Conditions of dry etching with CF₄ gas

Pressure: 3 Pa
Antenna RF power: 100 W
Bias RF power: 15 W
CF₄ gas flow rate: 15 sccm
Time: 30 sec

### Conditions of dry etching with O₂ gas

Pressure: 3 Pa
Antenna RF power: 300 W
Bias RF power: 10 W
O₂ gas flow rate: 25 sccm
Time: 30 sec

**[Table 8]**

| Example | Composition for forming metal-containing film | Etching rate (nm/min) | Etching rate (nm/min) |
|---|---|---|---|
| | | CF₄ | O₂ |
| Example 3-1 | MUL-1 | A | A |
| Example 3-2 | MUL-2 | A | A |
| Example 3-3 | MUL-3 | A | A |
| Example 3-4 | MUL-4 | A | A |
| Example 3-5 | MUL-5 | A | A |
| Example 3-6 | MUL-6 | A | A |
| Example 3-7 | MUL-7 | A | A |
| Example 3-8 | MUL-8 | A | A |
| Example 3-9 | MUL-9 | A | A |
| Example 3-10 | MUL-10 | A | A |
| Example 3-11 | MUL-11 | A | A |
| Example 3-12 | MUL-12 | A | A |
| Example 3-13 | MUL-13 | A | A |
| Example 3-14 | MUL-14 | A | A |
| Example 3-15 | MUL-15 | A | A |
| Example 3-16 | MUL-16 | A | A |
| Comparative Example 3-1 | Comparative MUL-1 | A | A |
| Comparative Example 3-2 | Comparative MUL-2 | A | A |
| Comparative Example 3-3 | SOG-1 | C | B |
| Comparative Example 3-4 | SOC-1 | B | C |

As shown in Table 8, it was shown that in Examples 3-1 to 3-16, where the inventive compositions (MUL-1 to -16) for forming a metal-containing film were used, the compositions all exhibited excellent etching resistance to CF₄ gas and O₂ gas.

The inventive compositions for forming a metal-containing film have better resistance than SOG-1, used in Comparative Example 3-3, to etching using CF₄ gas, and therefore, it can be said that the compositions are suitable for a three-layer resist process, where a resist pattern is transferred to a substrate to be processed by employing a combination with a resist underlayer film.

In addition, since the inventive compositions have better etching resistance to O₂ gas compared with SOC-1, used in Comparative Example 3-4, it can be said that the compositions are suitable for a two-layer resist process, where a resist pattern is transferred to a substrate to be processed by employing a combination with a photoresist upper layer film.

### [Patterning Process (Examples 4-1 to 4-14 and Comparative Examples 4-1 and 4-2)]

Using the above-described SOC-1, an SiO₂ wafer was spin-coated, and the coating film was baked at 350°C for 60 seconds to fabricate a carbon film having a thickness of 60 nm as a resist underlayer film on the substrate. The carbon film had a carbon content of 46 atomic% and the optical constants (n/k) at a wavelength of 193 nm were 1.42/0.50. A composition obtained by diluting one of the compositions (MUL-3 to -16 and comparative MUL-1 and -2) for forming a metal-containing film with an organic solvent (PGMEA/PGME = 700/300 parts by mass) was applied thereto, and heated by using a hot plate at the same temperature as that shown in Table 4 for 60 seconds to form a metal-containing film having a thickness of 15 nm. A monolayer resist for ArF as a resist upper layer film composition was applied thereto and baked at 105°C for 60 seconds to form a photoresist film having a thickness of 100 nm. A liquid immersion top coat composition (TC-1) was applied to the photoresist film and baked at 90°C for 60 seconds to form a top coat having a thickness of 50 nm.

The resist upper layer film material (monolayer resist for ArF) was prepared by dissolving a polymer (RP1), an acid generator (PAG1), and a basic compound (Amine1), each in the proportion shown in Table 9, in a solvent containing 0.1% by mass of a surfactant FC-4430 (available from Sumitomo 3M Limited), and filtering the solution through a 0.1-pm filter made of a fluororesin.

**[Table 9]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2,500) |

The polymer (RP1), the acid generator (PAG1), and the basic compound (Amine1) used for the resist upper layer film material (monolayer resist for ArF) are shown below.

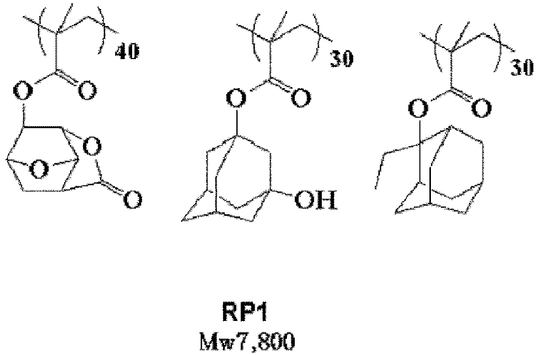

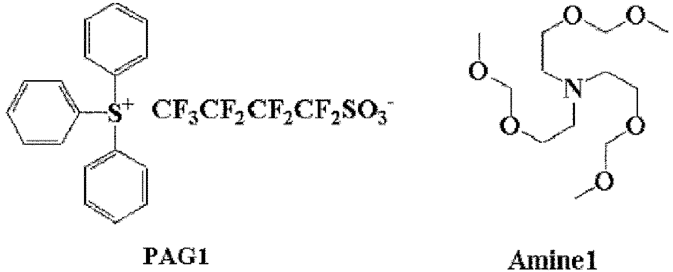

The liquid immersion top coat composition (TC-1) was prepared by dissolving a top coat polymer (PP1) in an organic solvent at the proportion shown in Table 10, and filtering the solution through a 0.1-pm filter made of a fluororesin.

**[Table 10]**

| | Top coat polymer (parts by mass) | Organic solvent (parts by mass) |
|---|---|---|
| TC-1 | PP1 (100) | Diisoamyl ether (2,700) 2-methyl-1-butanol (270) |

The top coat polymer (PP1) used for the liquid immersion top coat composition (TC-1) is shown below.

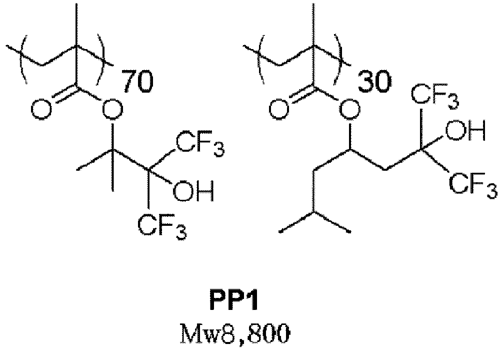

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 50 nm 1:1 positive line-and-space pattern (a resist upper layer film pattern).

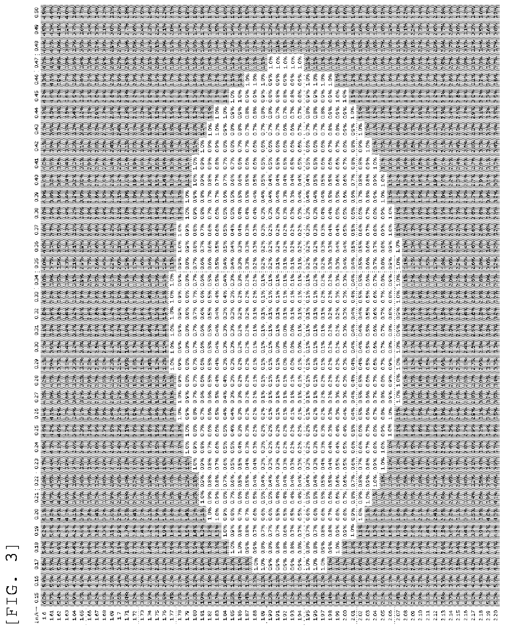

The calculation of reflectance was carried out using PROLITH 2020a (manufactured by Litho Tech Japan Corporation). With the film thickness of the metal-containing film fixed to 10 nm, the reflectance at which the "n" of the metal-containing film is 1.60 to 2.20 and the "k" is 0.15 to 0.50 was calculated, and the results are shown in FIG. 3. The optical constants (n/k) at which it is possible to reduce the reflected light from the underlying substrate during pattern exposure to 1.0% or less are preferable.

The pattern cross section was observed with S-4700 (electron microscope manufactured by Hitachi, Ltd.).

Table 11 shows the results.

Subsequently, the metal-containing film was etched by dry etching while using the resist upper layer film pattern as a mask to form a metal-containing film pattern, the resist underlayer film was etched while using the obtained metal-containing film pattern as a mask to form a resist underlayer film pattern, and the SiO₂ film was etched while using the obtained resist underlayer film pattern as a mask. The etching conditions were as follows.

The pattern cross section was observed with S-4700 (electron microscope manufactured by Hitachi, Ltd.).

Table 11 shows the results.

### Conditions in transferring resist upper layer film pattern to metal-containing film

### Conditions of dry etching with Cl₂ gas

Pressure: 1 Pa
Antenna RF power: 320 W
Bias RF power: 30 W
Cl₂ gas flow rate: 25 sccm
Time: 15 sec

### Conditions in transferring metal-containing film pattern to resist underlayer film

### Conditions of dry etching with O₂ gas

Pressure: 1 Pa
Antenna RF power: 300 W
Bias RF power: 10 W
O₂ gas flow rate: 25 sccm
Time: 20 sec

### Conditions in transferring resist underlayer film pattern to SiO₂ film

### Conditions of dry etching with CF₄ gas

Pressure: 1 Pa
Antenna RF power: 100 W
Bias RF power: 15 W
CF₄ gas flow rate: 15 sccm
Time: 60 sec

**[Table 11]**

| Example | Composition for forming metal-containing film | Reflectance | After development | After etching for transfer to substrate |
|---|---|---|---|---|
| | | % | Pattern profile | Pattern profile |
| Example 4-1 | MUL-3 | 0.6% | Vertical profile | Vertical profile |
| Example 4-2 | MUL-4 | 0.6% | Vertical profile | Vertical profile |
| Example 4-3 | MUL-5 | 0.5% | Vertical profile | Vertical profile |
| Example 4-4 | MUL-6 | 0.5% | Vertical profile | Vertical profile |
| Example 4-5 | MUL-7 | 0.4% | Vertical profile | Vertical profile |
| Example 4-6 | MUL-8 | 0.5% | Vertical profile | Vertical profile |
| Example 4-7 | MUL-9 | 0.4% | Vertical profile | Vertical profile |
| Example 4-8 | MUL-10 | 0.3% | Vertical profile | Vertical profile |
| Example 4-9 | MUL-11 | 0.3% | Vertical profile | Vertical profile |
| Example 4-10 | MUL-12 | 0.7% | Vertical profile | Vertical profile |
| Example 4-11 | MUL-13 | 0.7% | Vertical profile | Vertical profile |
| Example 4-12 | MUL-14 | 0.5% | Vertical profile | Vertical profile |
| Example 4-13 | MUL-15 | 0.3% | Vertical profile | Vertical profile |
| Example 4-14 | MUL-16 | 0.7% | Vertical profile | Vertical profile |
| Comparative Example 4-1 | Comparative MUL-1 | 1.4% | Pattern collapse | - |
| Comparative Example 4-2 | Comparative MUL-2 | 0.7% | Pattern collapse | - |

As shown in Table 11, in Examples 4-1 to 4-14, where the inventive compositions (MUL-3 to -16) for forming a metal-containing film were used, it was observed that the pattern profile after development was excellent in every case. It is conjectured that since the inventive compositions for forming a metal-containing film each contain a compound for forming a metal-containing film containing one of the groups represented by the formulae (a-1) to (a-3), the compositions have high adhesiveness to the resist pattern and also have optical constants that allow sufficient reduction in the light reflected from the substrate during pattern exposure, and that therefore, excellent resist patterns were obtained. In addition, after the etching after transference to the substrate, the resist upper layer film pattern was successfully transferred to the substrate in the end, and it was confirmed that the compositions can be used suitably in fine processing according to a multilayer resist method.

On the other hand, in Comparative Examples 4-1 and 4-2, using comparative MUL-1 and -2, which had a low contact angle in the contact angle evaluation, collapse of the resist upper layer film pattern was observed after development.

From the above, the inventive compound for forming a metal-containing film, the inventive composition containing the compound, and the inventive patterning processes using the composition provide high adhesiveness to a resist upper layer film pattern, have an effect of suppressing the collapse of a fine pattern, and give a high-rectangularity pattern profile of a resist upper layer film, and therefore, are particularly suitably used in multilayer resist processes and are extremely useful in fine patterning for manufacturing semiconductor devices.

The present description includes the following embodiments.
[1]: A compound for forming a metal-containing film, comprising: at least one metal atom selected from the group consisting of Ti, Zr, and Hf; and a ligand coordinated to the metal atom, wherein the ligand contains a group represented by any of the following formulae (a-1) to (a-3), 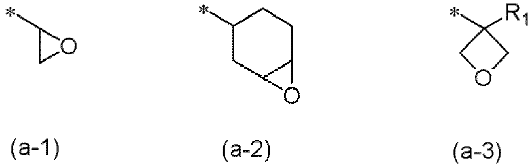 wherein R₁ represents a hydrogen atom or an organic group having 1 to 10 carbon atoms, and "*" represents an attachment point.
[2]: The compound for forming a metal-containing film of the above [1], wherein the ligand is derived from a structure represented by the following general formula (1) or (2),

   RₐXOH (1)

   RₐXCOOH (2)

   wherein Rₐ represents a group represented by any of the formulae (a-1) to (a-3); and X represents a divalent organic group having 1 to 20 carbon atoms.
[3]: The compound for forming a metal-containing film of the above [2], wherein the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 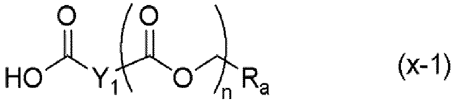 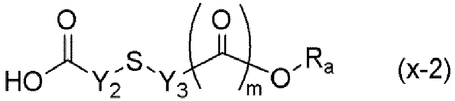 wherein Y₁ to Y₃ each represent a divalent organic group having 1 to 10 carbon atoms; Rₐ is as defined above; "n" represents 0 or 1; and "m" represents 0 or 1, 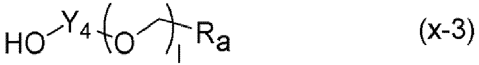 wherein Y₄ represents a divalent organic group having 1 to 10 carbon atoms; Rₐ is as defined above; and "l" represents 0 or 1.
[4]: The compound for forming a metal-containing film of the above [3], wherein the Y₁ to Y₄ are each a divalent hydrocarbon group having 1 to 10 carbon atoms.
[5]: The compound for forming a metal-containing film of any one of the above [2] to [4], wherein the compound for forming a metal-containing film is a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),

   **LₐMX_{b}** **(3)**

   wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.
[6]: The compound for forming a metal-containing film of the above [5], wherein the metal compound has a structure represented by the following general formula (4),

   M(OR^{1A})₄ (4)

   wherein M is as defined above; and R^{1A} represents a monovalent organic group having 1 to 20 carbon atoms.
[7] : The compound for forming a metal-containing film of any one of the above [1] to [6], further comprising a ligand derived from a silicon compound represented by the following general formula (5), 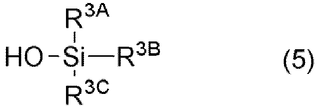 wherein R^{3A}, R^{3B}, and R^{3C} each represent any organic group selected from an organic group having 2 to 30 carbon atoms including a crosslinking group of a structure represented by any of the following general formulae (b-1) to (b-3), a substituted or unsubstituted alkyl group having 1 to 20 carbon atoms, and an aryl group having 6 to 20 carbon atoms, 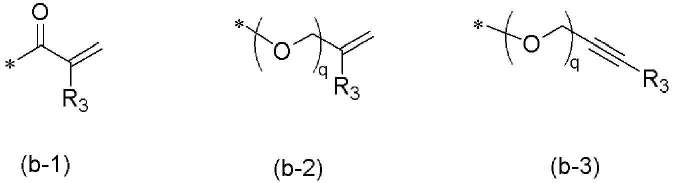 wherein R₃ represents a hydrogen atom or a monovalent organic group having 1 to 10 carbon atoms; "q" represents 0 or 1; and "*" represents an attachment point.
[8]: A composition for forming a metal-containing film, comprising: (A) the compound for forming a metal-containing film of any one of the above [1] to [7]; and (B) an organic solvent.
[9]: The composition for forming a metal-containing film of the above [8], further comprising one or more of (C) a thermal acid generator and (D) a photo-acid generator.
[10]: The composition for forming a metal-containing film of the above [8] or [9], further comprising one or more of (E) a crosslinking agent and (G) a surfactant.
[11]: The composition for forming a metal-containing film of any one of the above [8] to [10], wherein the organic solvent (B) is a mixture of one or more kinds of organic solvent having a boiling point of lower than 180°C and one or more kinds of organic solvent having a boiling point of 180°C or higher.
[12]: A patterning process for forming a pattern in a substrate to be processed, comprising the steps of:
   (I-1) applying the composition for forming a metal-containing film of any one of the above [8] to [11] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the transferred pattern as a mask to form the pattern in the substrate to be processed.
[13]: A patterning process for forming a pattern in a substrate to be processed, comprising the steps of:
   (II-1) forming a resist underlayer film on a substrate to be processed;
   (II-2) applying the composition for forming a metal-containing film of any one of the above [8] to [11] onto the resist underlayer film, followed by heating to form a metal-containing film;
   (II-3) forming a resist upper layer film on the metal-containing film by using a photoresist material;
   (II-4) subjecting the resist upper layer film to pattern exposure and then development with a developer to form a pattern in the resist upper layer film;
   (II-5) transferring the pattern to the metal-containing film by dry etching while using the resist upper layer film having the formed pattern as a mask;
   (II-6) transferring the pattern to the resist underlayer film by dry etching while using the metal-containing film having the transferred pattern as a mask; and
   (II-7) processing the substrate to be processed while using the resist underlayer film having the transferred pattern as a mask to form the pattern in the substrate to be processed.
[14]: A method for manufacturing a compound for forming a metal-containing film, the method comprising performing a reaction between: a metal compound containing at least one metal atom selected from the group consisting of Ti, Zr, and Hf; and a ligand containing a group represented by any of the following formulae (a-1) to (a-3), 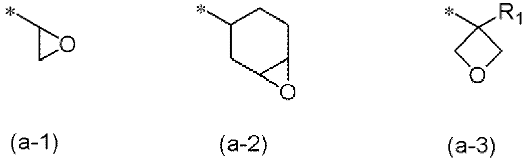 wherein R₁ represents a hydrogen atom or an organic group having 1 to 10 carbon atoms, and "*" represents an attachment point.
[15]: The method of the above [14] for manufacturing a compound for forming a metal-containing film, wherein the ligand has a structure represented by the following general formula (1) or (2),

   RₐXOH (1)

   RₐXCOOH (2)

   wherein Rₐ represents a group represented by any of the formulae (a-1) to (a-3); and X represents a divalent organic group having 1 to 20 carbon atoms.
[16]: The method of the above [15] for manufacturing a compound for forming a metal-containing film, wherein, in the ligand, the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 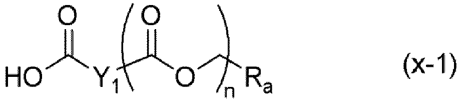 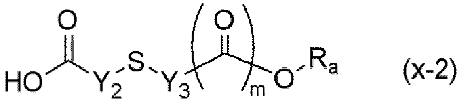 wherein Y₁ to Y₃ each represent a divalent organic group having 1 to 10 carbon atoms; Rₐ is as defined above; "n" represents 0 or 1; and "m" represents 0 or 1, 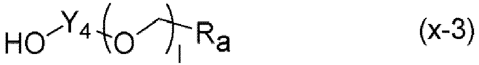 wherein Y₄ represents a divalent organic group having 1 to 10 carbon atoms; Rₐ is as defined above; and "l" represents 0 or 1.
[17] : The method of the above [16] for manufacturing a compound for forming a metal-containing film, wherein the Y₁ to Y₄ are each a divalent hydrocarbon group having 1 to 10 carbon atoms.
[18]: The method of any one of the above [15] to [17] for manufacturing a compound for forming a metal-containing film, wherein the compound for forming a metal-containing film is a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),

   LₐMX_{b} (3)

   wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.
[19]: The method of the above [18] for manufacturing a compound for forming a metal-containing film, wherein the metal compound has a structure represented by the following general formula (4),

   M(OR^{1A})₄ (4)

   wherein M is as defined above; and R^{1A} represents a monovalent organic group having 1 to 20 carbon atoms.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention. The present invention also refers to the following numbered embodiments, wherein the term "claim" means "embodiment":
1. A compound for forming a metal-containing film, comprising: at least one metal atom selected from the group consisting of Ti, Zr, and Hf; and a ligand coordinated to the metal atom, wherein the ligand contains a group represented by any of the following formulae (a-1) to (a-3), 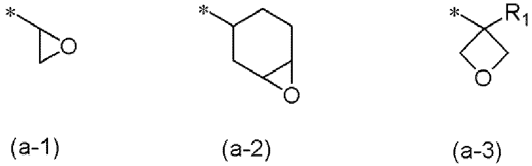 wherein R₁ represents a hydrogen atom or an organic group having 1 to 10 carbon atoms, and "*" represents an attachment point.
2. The compound for forming a metal-containing film according to claim 1, wherein the ligand is derived from a structure represented by the following general formula (1) or (2),

   RₐXOH (1)

   RₐXCOOH (2)

   wherein Rₐ represents a group represented by any of the formulae (a-1) to (a-3); and X represents a divalent organic group having 1 to 20 carbon atoms.
3. The compound for forming a metal-containing film according to claim 2, wherein the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 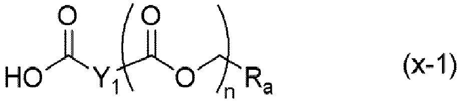 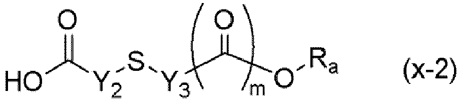 wherein Y₁ to Y₃ each represent a divalent organic group having 1 to 10 carbon atoms; Rₐ is as defined above; "n" represents 0 or 1; and "m" represents 0 or 1, 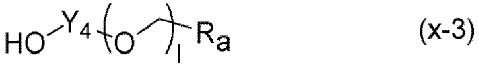 wherein Y₄ represents a divalent organic group having 1 to 10 carbon atoms; Rₐ is as defined above; and "l" represents 0 or 1.
4. The compound for forming a metal-containing film according to claim 3, wherein the Y₁ to Y₄ are each a divalent hydrocarbon group having 1 to 10 carbon atoms.
5. The compound for forming a metal-containing film according to any one of claims 2 to 4, wherein the compound for forming a metal-containing film is a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),

   LₐMX_{b} (3)

   wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.
6. The compound for forming a metal-containing film according to claim 5, wherein the metal compound has a structure represented by the following general formula (4),

   M(OR^{1A})₄ (4)

   wherein M is as defined above; and R^{1A} represents a monovalent organic group having 1 to 20 carbon atoms.
7. The compound for forming a metal-containing film according to any one of claims 1 to 6, further comprising a ligand derived from a silicon compound represented by the following general formula (5), 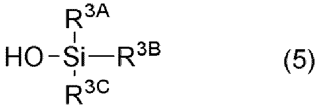 wherein R^{3A}, R^{3B}, and R^{3C} each represent any organic group selected from an organic group having 2 to 30 carbon atoms including a crosslinking group of a structure represented by any of the following general formulae (b-1) to (b-3), a substituted or unsubstituted alkyl group having 1 to 20 carbon atoms, and an aryl group having 6 to 20 carbon atoms, 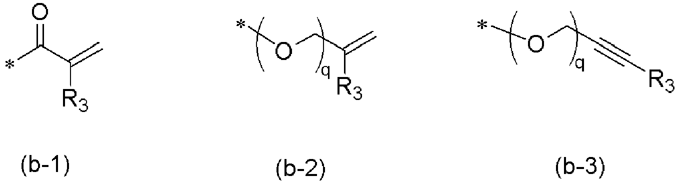 wherein R₃ represents a hydrogen atom or a monovalent organic group having 1 to 10 carbon atoms; "q" represents 0 or 1; and "*" represents an attachment point.
8. A composition for forming a metal-containing film, comprising: (A) the compound for forming a metal-containing film according to any one of claims 1 to 7; and (B) an organic solvent.
9. The composition for forming a metal-containing film according to claim 8, further comprising one or more of (C) a thermal acid generator and (D) a photo-acid generator.
10. The composition for forming a metal-containing film according to claim 8 or 9, further comprising one or more of (E) a crosslinking agent and (G) a surfactant.
11. The composition for forming a metal-containing film according to any one of claims 8 to 10, wherein the organic solvent (B) is a mixture of one or more kinds of organic solvent having a boiling point of lower than 180°C and one or more kinds of organic solvent having a boiling point of 180°C or higher.
12. A patterning process for forming a pattern in a substrate to be processed, comprising the steps of:
   (I-1) applying the composition for forming a metal-containing film according to any one of claims 8 to 11 onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the transferred pattern as a mask to form the pattern in the substrate to be processed.
13. A patterning process for forming a pattern in a substrate to be processed, comprising the steps of:
   (II-1) forming a resist underlayer film on a substrate to be processed;
   (II-2) applying the composition for forming a metal-containing film according to any one of claims 8 to 11 onto the resist underlayer film, followed by heating to form a metal-containing film;
   (II-3) forming a resist upper layer film on the metal-containing film by using a photoresist material;
   (II-4) subjecting the resist upper layer film to pattern exposure and then development with a developer to form a pattern in the resist upper layer film;
   (II-5) transferring the pattern to the metal-containing film by dry etching while using the resist upper layer film having the formed pattern as a mask;
   (II-6) transferring the pattern to the resist underlayer film by dry etching while using the metal-containing film having the transferred pattern as a mask; and
   (II-7) processing the substrate to be processed while using the resist underlayer film having the transferred pattern as a mask to form the pattern in the substrate to be processed.
14. A method for manufacturing a compound for forming a metal-containing film, the method comprising performing a reaction between: a metal compound containing at least one metal atom selected from the group consisting of Ti, Zr, and Hf; and a ligand containing a group represented by any of the following formulae (a-1) to (a-3), 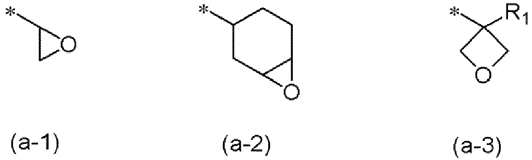 wherein R₁ represents a hydrogen atom or an organic group having 1 to 10 carbon atoms, and "*" represents an attachment point.
15. The method according to claim 14 for manufacturing a compound for forming a metal-containing film, wherein the ligand has a structure represented by the following general formula (1) or (2),

   RₐXOH (1)

   RₐXCOOH (2)

   wherein Rₐ represents a group represented by any of the formulae (a-1) to (a-3); and X represents a divalent organic group having 1 to 20 carbon atoms.
16. The method according to claim 15 for manufacturing a compound for forming a metal-containing film, wherein, in the ligand, the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 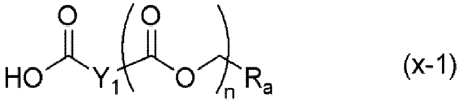 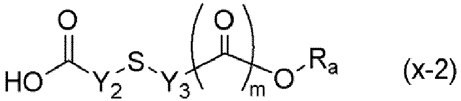 wherein Y₁ to Y₃ each represent a divalent organic group having 1 to 10 carbon atoms; Rₐ is as defined above; "n" represents 0 or 1; and "m" represents 0 or 1, 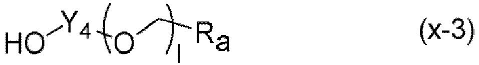 wherein Y₄ represents a divalent organic group having 1 to 10 carbon atoms; Rₐ is as defined above; and "l" represents 0 or 1.
17. The method according to claim 16 for manufacturing a compound for forming a metal-containing film, wherein the Y₁ to Y₄ are each a divalent hydrocarbon group having 1 to 10 carbon atoms.
18. The method according to any one of claims 15 to 17 for manufacturing a compound for forming a metal-containing film, wherein the compound for forming a metal-containing film is a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),

   LₐMX_{b} (3)

   wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4.
19. The method according to claim 18 for manufacturing a compound for forming a metal-containing film, wherein the metal compound has a structure represented by the following general formula (4),

   M(OR^{1A})₄ (4)

   wherein M is as defined above; and R^{1A} represents a monovalent organic group having 1 to 20 carbon atoms.

## Claims

1. A compound for forming a metal-containing film, comprising: at least one metal atom selected from the group consisting of Ti, Zr, and Hf; and a ligand coordinated to the metal atom, wherein the ligand contains a group represented by any of the following formulae (a-1) to (a-3), 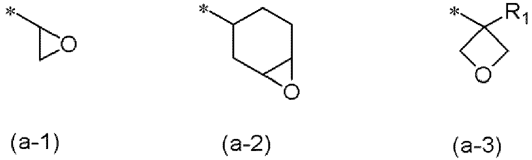 wherein R₁ represents a hydrogen atom or an organic group having 1 to 10 carbon atoms, and "*" represents an attachment point.

2. The compound for forming a metal-containing film according to claim 1, wherein the ligand is derived from a structure represented by the following general formula (1) or (2),
RₐXOH (1)
RₐXCOOH (2)
wherein Rₐ represents a group represented by any of the formulae (a-1) to (a-3); and X represents a divalent organic group having 1 to 20 carbon atoms.

3. The compound for forming a metal-containing film according to claim 2, wherein the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 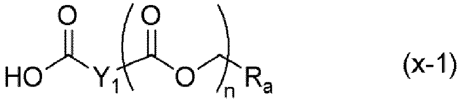 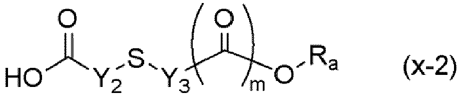 wherein Y₁ to Y₃ each represent a divalent organic group having 1 to 10 carbon atoms; Rₐ is as defined above; "n" represents 0 or 1; and "m" represents 0 or 1, 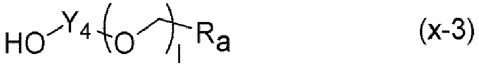 wherein Y₄ represents a divalent organic group having 1 to 10 carbon atoms; Rₐ is as defined above; and "l" represents 0 or 1.

4. The compound for forming a metal-containing film according to claim 3, wherein the Y₁ to Y₄ are each a divalent hydrocarbon group having 1 to 10 carbon atoms.

5. The compound for forming a metal-containing film according to any one of claims 2 to 4, wherein the compound for forming a metal-containing film is a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),
LₐMX_{b} (3)
wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4;
preferably
wherein the metal compound has a structure represented by the following general formula (4),
M(OR^{1A})₄ (4)
wherein M is as defined above; and R^{1A} represents a monovalent organic group having 1 to 20 carbon atoms.

6. The compound for forming a metal-containing film according to any one of claims 1 to 5, further comprising a ligand derived from a silicon compound represented by the following general formula (5), 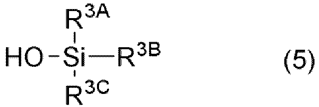
wherein R^{3A}, R^{3B}, and R^{3C} each represent any organic group selected from an organic group having 2 to 30 carbon atoms including a crosslinking group of a structure represented by any of the following general formulae (b-1) to (b-3), a substituted or unsubstituted alkyl group having 1 to 20 carbon atoms, and an aryl group having 6 to 20 carbon atoms, 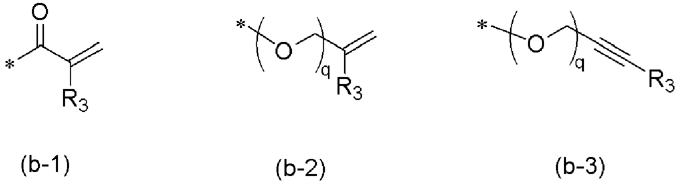
wherein R₃ represents a hydrogen atom or a monovalent organic group having 1 to 10 carbon atoms; "q" represents 0 or 1; and "*" represents an attachment point.

7. A composition for forming a metal-containing film, comprising: (A) the compound for forming a metal-containing film according to any one of claims 1 to 6; and (B) an organic solvent.

8. The composition for forming a metal-containing film according to claim 7, further comprising one or more of (C) a thermal acid generator and (D) a photo-acid generator.

9. The composition for forming a metal-containing film according to claim 7 or 8, further comprising one or more of (E) a crosslinking agent and (G) a surfactant.

10. The composition for forming a metal-containing film according to any one of claims 7 to 9, wherein the organic solvent (B) is a mixture of one or more kinds of organic solvent having a boiling point of lower than 180°C and one or more kinds of organic solvent having a boiling point of 180°C or higher.

11. A patterning process for forming a pattern in a substrate to be processed, comprising the steps of:
A)
(I-1) applying the composition for forming a metal-containing film according to any one of claims 7 to 10 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the transferred pattern as a mask to form the pattern in the substrate to be processed;
or
B)
(II-1) forming a resist underlayer film on a substrate to be processed;
(II-2) applying the composition for forming a metal-containing film according to any one of claims 7 to 10 onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the transferred pattern as a mask to form the pattern in the substrate to be processed.

12. A method for manufacturing a compound for forming a metal-containing film, the method comprising performing a reaction between: a metal compound containing at least one metal atom selected from the group consisting of Ti, Zr, and Hf; and a ligand containing a group represented by any of the following formulae (a-1) to (a-3), 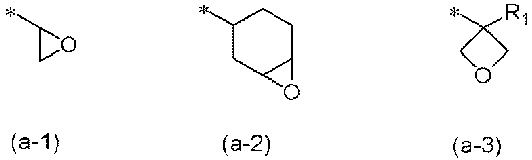 wherein R₁ represents a hydrogen atom or an organic group having 1 to 10 carbon atoms, and "*" represents an attachment point.

13. The method according to claim 12 for manufacturing a compound for forming a metal-containing film, wherein the ligand has a structure represented by the following general formula (1) or (2),
RₐXOH (1)
RₐXCOOH (2)
wherein Rₐ represents a group represented by any of the formulae (a-1) to (a-3); and X represents a divalent organic group having 1 to 20 carbon atoms.

14. The method according to claim 13 for manufacturing a compound for forming a metal-containing film, wherein, in the ligand, the X is a hydrocarbon group having 1 to 10 carbon atoms, the structure represented by the general formula (2) is a structure represented by the following general formula (x-1) or (x-2), or the structure represented by the general formula (1) is a structure represented by the following formula (x-3), 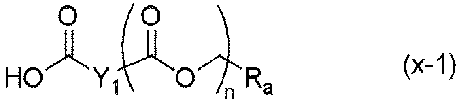 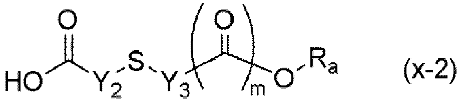 wherein Y₁ to Y₃ each represent a divalent organic group having 1 to 10 carbon atoms; Rₐ is as defined above; "n" represents 0 or 1; and "m" represents 0 or 1, 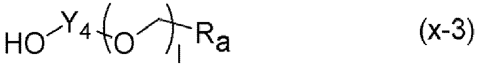
wherein Y₄ represents a divalent organic group having 1 to 10 carbon atoms; Rₐ is as defined above; and "l" represents 0 or 1;
preferably
wherein the Y₁ to Y₄ are each a divalent hydrocarbon group having 1 to 10 carbon atoms.

15. The method according to claim 13 or 14 for manufacturing a compound for forming a metal-containing film, wherein the compound for forming a metal-containing film is a reaction product of a reaction between: a metal compound represented by the following general formula (3) or a metal-containing compound containing a hydrolysate, condensate, or hydrolysis condensate of the metal compound represented by the following general formula (3); and the structure represented by the general formula (1) or (2),
LₐMX_{b} (3)
wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b = 4, "a" and "b" each representing an integer of 0 to 4;
preferably
wherein the metal compound has a structure represented by the following general formula (4),
M(OR^{1A})₄ (4)
wherein M is as defined above; and R^{1A} represents a monovalent organic group having 1 to 20 carbon atoms.
